(19) Europäisches Patentamt / European Patent Office / Office européen des brevets

(11) **EP 3 051 600 A1**

(12) **EUROPEAN PATENT APPLICATION**

(43) Date of publication:
**03.08.2016 Bulletin 2016/31**

(51) Int Cl.:
***H01L 51/42*** (2006.01) *H01L 51/44* (2006.01)

(21) Application number: **15382026.1**

(22) Date of filing: **30.01.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **Consejo Superior De Investigaciones Científicas**
  **28006 Madrid (ES)**
- **ISIS INNOVATION LIMITED**
  **Summertown,**
  **Oxford OX2 7SG (GB)**

(72) Inventors:
- **Miguez, Hernán**
  **E-28006 Madrid (ES)**
- **Anaya, Miguel**
  **E-28006 Madrid (ES)**
- **Calvo, Mauricio E.**
  **E-28006 Madrid (ES)**
- **Lozano Barbero, Gabriel Sebastián**
  **E-28006 Madrid (ES)**
- **Snaith, Henry J.**
  **Summertown - Oxford, OX2 7SG (GB)**
- **Zhang, Wei**
  **Summertown - Oxford, OX2 7SG (GB)**

(74) Representative: **Goddard, Christopher Robert**
**Dehns**
**St Bride's House**
**10 Salisbury Square**
**London**
**EC4Y 8JD (GB)**

(54) **HETEROJUNCTION DEVICE**

(57) The invention relates to a solid-state heterojunction comprising a photoactive layer comprising a photoactive perovskite and an optical multilayer in contact with the photoactive layer. The invention further relates to an optoelectronic device comprising at least one such solid-state heterojunction and to a construction material comprising at least one such optoelectronic device. In a further aspect the invention relates to the use of an optical multilayer in a solid-state heterojunction comprising a photoactive perovskite.

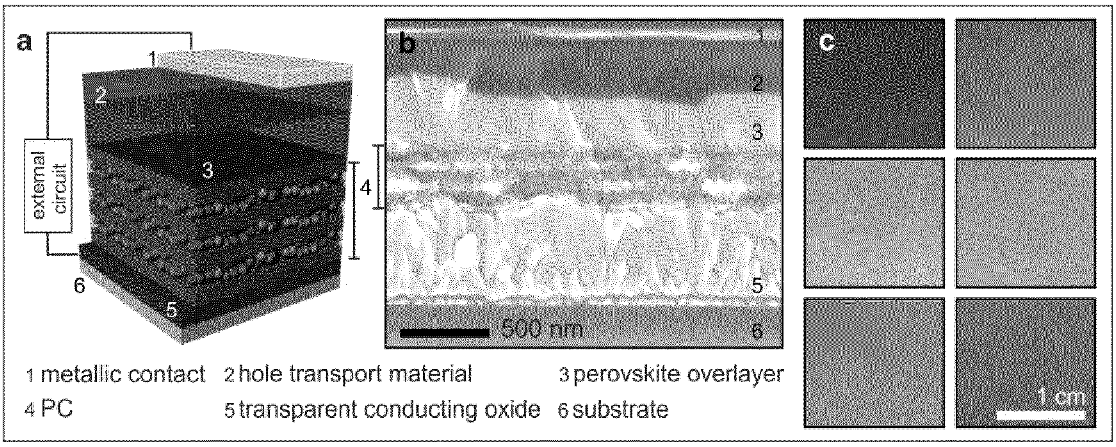


**Figure 1**

EP 3 051 600 A1

## Description

### Field of the Invention

The present invention relates to a solid-state heterojunction, in particular a solid-state heterojunction comprising a perovskite, and to the use of such heterojunctions in optoelectronic devices such as solid-state solar cells and corresponding light sensing devices as well as in light-emitting diodes. The invention further relates to such heterojunctions which exhibit structural colour. Certain novel optical multilayers (such as one-dimensional photonic crystals) which may impart such a structural colour themselves form a further aspect of the invention. Most particularly, the present invention relates to solid-state heterojunctions which exhibit strong structural colour and which are suitable for use in building integrated photovoltaic (BIPV) applications. In a further aspect the invention also relates to novel optical multilayers, and in particular novel one-dimensional photonic crystals (1DPCs).

### Background of the Invention

The junction of an n-type semiconductor material (known as an electron transporter) with a p-type semiconductor material (known as a hole-transporter) is perhaps the most fundamental structure in modem electronics. This so-called "heterojunction" forms the basis of most modem diodes, transistors and related devices including optoelectronic devices such as light emitting diodes (LEDs), photovoltaic cells, and electronic photosensors. The additional insertion of a layer of intrinsic ("i-type" or simply "i") semiconductor between the p-type and n-type materials can also have advantageous properties in some optoelectronic applications such as solar cells or light emitting diodes, where the optoelectronic properties of the intrinsic photoactive material may be superior when the material is not heavily doped. Such so-called "p-i-n heterojunctions" are particularly relevant in the context of perovskite solar cells.

A realisation of the pressing need to secure sustainable future energy supplies has led to a recent explosion of interest in photovoltaics (PV). Photovoltaic (PV) solar energy has the prospect to supply global energy demands hundreds of times over. A large fraction of the cost of solar energy arises from the fixed costs of land, frames, supports and services. One approach to reducing these fixed costs is to build the photovoltaic cells directly into infrastructure and supports already constructed for other purposes, such as building facades, fences, walls, awnings and automotive skins. However, for widespread uptake of building integrated photovoltaics (BIPVs), the photovoltaic cell should ideally be aesthetically appealing.

One common type of photovoltaic cell is the dye-sensitised solar cell (DSC or DSSC). Typically, DSCs are composed of mesoporous $TiO_2$ (electron transporter) sensitized with a light-absorbing molecular dye, which in turn is contacted by a redox-active hole-transporting solution (electrolyte). However, such liquid electrolyte devices suffer from a number of shortcomings: the efficiency is far from optimal; the systems are typically optimised to operate with sensitizers which predominantly absorb in the visible region of the spectrum thereby losing out on significant photocurrent and energy conversion; and liquid electrolytes are normally corrosive and often prone to leakage, factors which become particularly problematic for larger-scale installations or over longer time periods.

More recently, photovoltaic devices (solar cells) employing perovskites as solid-state light-absorbing and/or charge-transport materials, have been developed. These are sometimes referred to as perovskite solar cells (PSCs). Perovskites are advantageous in that these are able to act not only as a sensitizer (light absorber) but also as an n-type, p-type or intrinsic (i-type) semiconductor material (charge transporter). A perovskite can therefore act both as a sensitizer and as the n-type semiconductor material. In this way the perovskite may assume the roles both of light absorption and long range charge transport. Perovskites are often more strongly absorbing over a broader wavelength range than dyes, thus offering enhanced light absorption as well the opportunity to use thinner films than are feasible with DSCs.

Conventionally, PSCs employ a solid-state (e.g. organic semiconductor) p-type material. Solid-state heterojunction devices employing solid-state p-type materials (e.g. solid-state organic p-type materials such as spiro-OMeTAD or solid-state inorganic p-type materials such as CuSCN) are advantageous in that they do not suffer from electrolyte leakage, nor does the hole-transporting material (HTM) possess corrosive qualities. Currently-known devices are also relatively cheap to manufacture and have achieved performance comparable to or much greater than liquid electrolyte dye-sensitized solar cell systems. Perovskite-based solar cells thus offer high performance at relatively low cost.

In principle, perovskite-based solar cells are versatile and can be applied to any type of surface. However, due to the strong absorbance of perovskites over a wide range of visible wavelengths, perovskite-based solar cells are normally very dark or opaque in colour and have little aesthetic appeal or versatility, thus limiting their application in the burgeoning field of building-integrated photovoltaics.

In an attempt to alleviate the unattractive physical appearance of perovskite solar cells, previous efforts have included measures such as tuning the chemical composition of the perovskite. However, the resulting device performance is highly dependent on the chemical composition of the perovskite. It is of great importance to maintain the basic structure of the active layers when introducing materials that lead to coloration, in order to ensure a working device. Furthermore,

the colour generated by such methods is a function of the bandgap within the perovskite and therefore only a relatively limited range of colours are accessible.

For use in building-integrated applications, for example in the façade of a building or the bodywork of a motor vehicle, it is therefore desirable to provide a perovskite-based solar cell (such as a perovskite-based solid state solar cell) which is attractively coloured without significantly impairing the functionality of the solar cell or restricting the available colour wavelengths. Moreover, the intended application of such solar cells in the built environment demands a lifetime of years or even decades without significant degradation or loss of colour. Pigments or dyes may not only interfere with the functioning of a solar cell but may also undergo degradation and/or bleaching with exposure to sunlight and other environmental conditions. It is therefore desirable to provide perovskite-based solar cells which have a durable colour.

The present inventors have realised that structural colour provides a route to the production of attractively-coloured perovskite-based solar cells. By structural colour is meant the principle whereby microscopic structures within an object (here, a heterojunction device) interfere with the reflection of visible light, thereby altering the perceived colour of the object. Such structural colours are widespread in nature, where they are used by animals for signalling, mimicry, and mate choice, or by plants for attracting an animal and being dispersed. Well-known examples occur in the wings of butterflies and the shells of certain beetles, which each incorporate a layer of overlapping scales. The scales are covered with thin parallel veins which function in a manner similar to a diffraction grating, giving rise to wavelength-specific reflections.

Structural colours have several unique features when compared to pigmentary colours, such as higher visibility, angular dependence, iridescence, polarization effects, long-term stability, and tuneability.

Multilayers formed by alternating layers of different refractive index are often used to obtain structural colour. This effect results from the optical interference of light beams partially reflected and transmitted at the multiple interfaces present in the structure. Boundaries between regions having different refractive indices lead to partial reflection of optical waves incident at the boundary and thus waves reflected from different boundaries within the material interfere, producing a colour. In principle, structural colour can be achieved employing periodic, aperiodic or even random stacks of layers, provided that adjacent layers differ in refractive index. Structural colour can thus be obtained using layers of material which, individually, appear colourless. The colour obtained by a multilayer arrangement can be finely tuned through the thickness and refractive index of the constituent layers.

One requirement for the production of structural colour via a multilayer arrangement is that each layer in the stack is of "optical quality", which means that light would not be diffusely scattered to a significant extent when impinging into any individual layer considered alone. For the purposes of the present invention as herein described, "optical quality" may for example mean that light would be diffusely scattered by less than 5% when impinging onto any individual layer considered in isolation.

A multilayer as described above will be referred to herein as a "photonic multilayer" or "optical multilayer" (these terms being equivalent for the purposes of this application). As used herein, the term "multilayer" thus refers to a photonic multilayer (equivalently called an optical multilayer) and describes a structure comprising at least two layers in which the refractive index of adjacent layers is different.

A multilayer structure consisting of a periodic alternation of two or more layers of different refractive index is commonly referred to as a one-dimensional photonic crystal (1DPC). Other common names for such a structure include Bragg mirror, dichroic mirror, interference mirror or dielectric mirror. 1DPCs are thus one route to producing structural colour and present a spatial modulation of the refractive index. The periodic variation in refractive index causes the structure to act as a wavelength-specific dielectric mirror. The wavelength reflected, and the breadth or narrowness of the reflected bandwidth, can be tuned by careful selection of the refractive indices of the different regions within the periodic structure. In this way the use of a photonic crystal allows access to a wide range of reflected colours.

Dye-sensitized solar cells (DSCs or DSSCs) incorporating one-dimensional photonic crystals (1DPC) have previously been described, for example in Colodrero et al., Advanced Materials, 2009, vol. 21, pp. 764-770; in United States Patent Application Publication US 2011/0030792 to Miguez et al.; and in Colonna et al., Energy & Environmental Science, 2012, vol. 5, pp. 8238-8243. In a first configuration of such devices, the 1DPC is employed as a "back reflector" interposed between the light-absorbing layer and the liquid electrolyte. The 1DPC acts to partially localise photons of a certain wavelength range within the light-absorbing layer, therefore increasing their probability of optical absorption. In order to allow charge transport between the light absorbing layer and the liquid electrolyte the 1DPC must be porous so that the liquid electrolyte can flow through the 1DPC with as little impact as possible on the conductivity of ions, responsible for charge transport through the cell.

In a second configuration of DSCs incorporating 1DPCs, a 1DPC is included in the cell in the form of a photoconductive Bragg mirror which functions as an electrode. In that case, the interest lies in the observation of the effect of well-defined optical resonances on the spectral dependence of the photocurrent curve as described in M. Anaya et al., JACS 2013, 135, 7803. An example of such a configuration, employing a 1DPC constructed from alternating layers of higher and lower porosity mesoporous $TiO_2$, is described in M.E. Calvo et al., Adv. Funct. Mater. 2008, 18, 2708-2715. However, such $TiO_2$ multilayers with variable porosity do not present a significant refractive index contrast, and therefore

do not provide intense colour effects.

In the present invention, the inventors have developed a novel optical multilayer with extremely high colour selective reflectivity. The optical multilayer of the invention can be integrated within the photoactive layer of an opaque perovskite solar cell. Unlike the previously-described DSCs incorporating 1DPCs, the structure of the novel optical multilayer is not constrained by the requirement to allow flow-through of a liquid electrolyte during solar cell operation. In contrast to the previously-described 1DPC-incorporating DSSCs, where the reflection of light by the 1DPC assists in enhancing light absorption by the photoactive layer and thus serves to increase the efficiency of the cell, in the present invention the reflection of light from the optical multilayer does not materially affect the absorption of light by the photoactive layer. The optical multilayer can be configured to allow an essentially unfettered choice of colour. This now imbues the perovskite solar cells with highly desirable properties for cladding in the build environment, and encourages design of sustainable colourful buildings and iridescent electric vehicles as future power generation sources.

An unexpected advantage of the colourful perovskite solar cells is that the additional reflected light will reduce the thermal gain within the solar cell and in the building, which may have added benefits of lower operating temperatures of the solar cells, and hence increasing efficiency under real world conditions, and reducing the cooling demand in buildings.

<u>Overview of the Invention</u>

In a first aspect, the present invention therefore provides a solid-state heterojunction comprising a photoactive layer comprising a photoactive perovskite and an optical multilayer in contact with the photoactive layer.

In another aspect, the present invention provides a solid-state heterojunction comprising:

a photoactive layer comprising a photoactive perovskite,
an n-type layer,
an optical multilayer interposed between the photoactive layer and the n-type layer, and optionally
a p-type layer separated from the optical multilayer by the photoactive layer.

In a further aspect, the present invention provides a solid-state inverted heterojunction comprising:

a photoactive layer comprising a photoactive perovskite,
a p-type layer,
an optical multilayer interposed between the photoactive layer and the p-type layer, and optionally
an n-type layer separated from the optical multilayer by the photoactive layer.

In a further aspect, the invention provides an optoelectronic device comprising at least one solid-state heterojunction as herein described.

In a further aspect, the invention provides the use of an optical multilayer in a solid-state heterojunction comprising a photoactive perovskite.

In a further aspect, the invention provides a method of providing structural colour in a solid-state heterojunction comprising a photoactive perovskite, said method comprising

(i) providing an optical multilayer; and
(ii) incorporating said optical multilayer into a solid-state heterojunction comprising a photoactive perovskite.

In a further aspect, the invention provides a method for the manufacture of a solid-state heterojunction comprising a photoactive layer comprising a photoactive perovskite, an n-type layer, an optical multilayer interposed between the photoactive layer and the n-type layer, and a p-type layer separated from the optical multilayer by the photoactive layer, said method comprising:

a) coating an anode, preferably a transparent anode (e.g. a Fluorine doped Tin Oxide (FTO) anode) with a layer of an n-type material, preferably a metal oxide;
b) forming an optical multilayer on at least a portion of a surface of said layer of an n-type material;
c) forming a layer of a photoactive perovskite contacting said optical multilayer;
e) optionally forming a layer of a p-type material in contact with said layer of photoactive perovskite;
f) optionally forming a permeable barrier layer comprising at least one porous (meso or micro) insulating material;
g) optionally forming a cathode, preferably a metal or metallic cathode (e.g. a silver or gold cathode), a transparent conducting oxide cathode, or a cathode formed from metal nanowires.

In a further aspect, the invention provides a method for the manufacture of a solid-state inverted heterojunction comprising a photoactive layer comprising a photoactive perovskite, a p-type layer, an optical multilayer interposed between the photoactive layer and the p-type layer, and an n-type layer separated from the optical multilayer by the photoactive layer, said method comprising:

a) coating a cathode, preferably a transparent anode (e.g. a Fluorine doped Tin Oxide (FTO) cathode) with a layer of a p-type material;
b) forming an optical multilayer on at least a portion of a surface of said layer of a p-type material;
c) forming a layer of a photoactive perovskite contacting said optical multilayer;
e) optionally forming a layer of an n-type material in contact with said layer of photoactive perovskite;
f) optionally forming a permeable barrier layer comprising at least one porous (meso or micro) insulating material;
g) optionally forming an anode, preferably a metal or metallic anode (e.g. a silver or gold anode), a transparent conducting oxide anode, or an anode formed from metal nanowires. In a further aspect, the invention provides a solid-state heterojunction formed or formable by the methods described herein.

In a further aspect, the invention provides an optoelectronic device comprising at least one solid-state heterojunction formed or formable by the methods described herein.

In a further aspect, the invention provides an optical multilayer comprising alternate layers of a first material having a first refractive index and a second material having a second refractive index, wherein the first refractive index and the second refractive index are different.

In a further aspect, the invention provides an optical multilayer comprising alternate layers of a first material having a first porosity and a second material having a second porosity, wherein the second porosity is higher than the first porosity.

Brief Description of the Drawings

The foregoing aspects and many of the advantages of the invention will become more readily appreciated by reference to the following detailed description taken in conjunction with the accompanying drawings, in which:

**Figure 1 a** shows a schematic of a perovskite solar cell incorporating an optical multilayer. **1b** shows a secondary electron scanning electron microscope image of a cross section of an optical multilayer--based solar cell. The optical multilayer is made by the alternated deposition of $SiO_2$ nanoparticles and $TiO_2$ layers. The device comprises gold as a metallic contact, spiro-OMeTAD as a hole transport material, the optical multilayer is infiltrated by $CH_3NH_3PbI_3$, fluorinated tin oxide as transparent conducting oxide. The cell is deposited over a glass substrate. **1c** shows Colours (from blue to red) displayed by devices integrating different optical multilayers.

**Figure 2 a** shows experimental (solid lines) and theoretical reflectance (dashed lines) of the orange (upper trace, orange lines) and blue-green (lower trace dark cyan lines) optical multilayer-based perovskite solar cells. Orange curves are vertically shifted by 0.3 for the sake of clarity. **2b**-**c** show calculated spatial (vertical axis) and spectral (horizontal axis) distribution of the electric field intensity enhancement ($E|^2/|E_0|^2$), i.e. near-field intensity normalized by the incident intensity, along a cross section of the solar cell, for the **b,** orange, and **c,** blue-green optical multilayer-based cells. Calculations were carried out considering the multilayer parameters extracted from the fittings to the reflectance measurements: **b,** $d_H$ = 58 nm, $d_L$ = 87 nm, and **c,** $d_H$ = 39 nm, $d_L$ = 90 nm. Horizontal dashed lines are guides to the eye to delimit the interfaces between layers in the solar cells. The bottom of the images is the glass side, and the top, the gold electrode side. **2d** shows CIE 1931 chromaticity space, showing the colour hues of the (1) orange (0.41, 0.40), and (2) blue-green (0.29, 0.35) optical multilayer-based cells. The dashed black line delimits the device colour gamut. It encompasses all different hues that can be achieved tuning the lattice parameter from 20 nm to 300 nm, and the thickness ratio of the high and low index material of the optical multilayer. The porosities of the high and low index materials are considered to be 5% and 50%, respectively.

**Figure 3** shows device performance of perovskite solar cells with -370 nm thick mesoporous $SiO_2$ as scaffold.

**Figure 4** shows device performance of perovskite solar cells based on optical multilayers comprising of alternating mesoporous $TiO_2$ and $SiO_2$ layers with lattice parameter of 180 nm and total multilayer thickness around 800 nm.

**Figure 5** shows current-density/voltage (J-V) curves of the typical device using an optical multilayer (a) and mesoporous $SiO_2$ (c) as scaffold, measured under simulated AM1.5 sunlight of 100mW/$cm^2$ irradiance, and the corresponding stabilized current density and power output of the same device using an optical multilayer (b) and mes-

oporous $SiO_2$ (d) as scaffold. All J-V scans were performed from forward bias to short circuit (FB-SC) and from short circuit to forward bias (SC-FB) at a scan rate of 0.15V/s.

**Figure 6** shows electrical characterization and device performance analysis. **a**-**c**, Spectral dependence of the external quantum efficiency of **a,** a non-photonic structured $SiO_2$ scaffold-based perovskite solar cell, which acts as a reference, **b,** an *orange* optical multilayer-based cell, and **c,** *blue-green* optical multilayer-based cell. The shaded areas correspond to the spectral regions in which the optical multilayer-based cells show high reflectance. **d-g,** Box-plot of the device performance indicators for the different optical multilayer-based cells: **d,** short-circuit current density (Jsc), **e,** open circuit voltage (Voc), **f,** power conversion efficiency (PCE), and **g,** fill factor **(FF). h-j,** Digital camera pictures of the devices labeled as (h) blue, (i) green and (j) orange.

**Figure 7** shows (a) backscattered electron and (b) FESEM images of a detail of the optical multilayer scaffold infiltrated by the perovskite. (From bottom to top: FTO, three bilayers of low porosity $TiO_2$ and high porosity $SiO_2$ infiltrated by perovskite and a final low porosity $TiO_2$ layer.)

<u>Detailed Description of the Invention</u>

In a first aspect, the present invention therefore provides a solid-state heterojunction comprising a photoactive layer comprising a photoactive perovskite and an optical multilayer in contact with the photoactive layer.

In another aspect, the present invention provides a solid-state heterojunction comprising:

a photoactive layer comprising a photoactive perovskite,
an n-type layer,
an optical multilayer interposed between the photoactive layer and the n-type layer, and optionally a p-type layer separated from the optical multilayer by the photoactive layer.

In a further aspect, the present invention provides a solid-state inverted heterojunction comprising:

a photoactive layer comprising a photoactive perovskite,
a p-type layer,
an optical multilayer interposed between the photoactive layer and the p-type layer, and optionally an n-type layer separated from the optical multilayer by the photoactive layer.

An optical multilayer (also called a photonic multilayer or herein equivalently "multilayer" for brevity) is a stack of layers of optical quality (i.e. not giving rise to diffuse light scattering) having different refractive indices. These structures can be designed to reflect an arbitrarily broad range or ranges of wavelength within the electromagnetic spectrum.

An optical multilayer such as the optical multilayer employed in the heterojunction of the invention comprises a plurality of layers (i.e. at least 2 layers) having different refractive indices. Conventionally the refractive index is given the symbol n. In an embodiment, therefore, an optical multilayer employed in the heterojunction of the invention may comprise at least a first and a second layer which differ in refractive index by at least 1, e.g. by at least 1.05, at least 1.10 or at least 1.15.

The optical multilayer functions as a distributed Bragg reflector. The bandwidth of the reflected light and the central wavelength of the reflected band can be determined by the thickness and refractive index of the constituent layers. By using layers having appropriate refractive indices the reflectivity profile can therefore be tuned to reflect a desired wavelength and to broaden or narrow the bandwidth of reflected light accordingly.

When the arrangement of the layers is periodic, i.e. when the multilayer comprises alternating layers of a first refractive index $n_1$ and a second refractive index $n_2$, where all layers of refractive index $n_1$ have the same thickness as one another and all layers of refractive index $n_2$ have the same thickness as one another (which may be the same as, or different from, the thickness of the $n_1$ layers) the optical multilayer may be referred to as a one-dimensional photonic crystal (1DPC). A one-dimensional photonic crystal as described herein forms a preferred "optical multilayer" in all aspects of the present invention.

The refractive index of the layer having the higher refractive index in a 1DPC may therefore be designated $n_H$ and the refractive index of the layer having the lower refractive index in a 1DPC may be designated $n_L$. Where more than 2 layers are present it is preferred that adjacent layers alternate in refractive index such that the (i)th layer and the (i+*2*)th layer have the same refractive index. Where more than 2 layers are present it is further preferred that the total number of layers present in the one-dimensional photonic crystal is an even integer, e.g. 2 layers, 4 layers, 6 layers, 8 layers, etc. such that the first layer of the photonic crystal and the final layer of the photonic crystal differ from one another in refractive index.

In the case of a 1DPC acting as a distributed Bragg reflector the bandwidth of the reflected light, and the central wavelength of the reflected band, can be determined according to the following equation:

$$\Delta\lambda_0 = \frac{4\lambda_0}{\pi}\sin^{-1}\left(\frac{n_H - n_L}{n_H + n_L}\right)$$

where $\lambda_0$ is the central wavelength of the band and $\Delta\lambda_0$ is the bandwidth of the band.

Where 1DPCs have been employed previously in DSCs these have comprised alternating nanoparticle-based layers of high (about 50%) porosity and substantially similar thickness but comprising different materials, such as alternating layers of $TiO_2$ and $SiO_2$, in order to produce the required alternation of refractive index. If similar 1DPCs are employed in the perovskite-based heterojunctions of the present invention, in order to obtain a vivid colour it would be necessary to employ a thick 1DPC (800 nm in thickness) and the device performance suffers, giving a power conversion efficiency (PCE) of below 0.5%.

It has surprisingly been found that, in the solid-state perovskite-based heterojunctions of the invention, vivid coloration can be obtained without excessively compromising PCE if a multilayer is employed which comprises alternating low porosity and high porosity layers. This is in contrast to the previously-used 1DPCs for DSCs, in which the alternating layers have substantially the same level of porosity as one another (about 50%). The thickness of individual layers may, for example, be controlled by careful selection of spin coating speeds during manufacture of the device where spin coating may be employed.

Suitably the high porosity layer may comprise nanoparticles (i.e. particles having a size (e.g. diameter) between 1 nm and 100 nm) and the low porosity layer may be a compact layer. "High porosity" in this context refers to a porosity of about 40% or above, e.g. about 45% or above, for example about 50%. "Low porosity" in this context refers to a porosity of about 10% or below, particularly preferably about 5% or below, e.g. a porosity of about 3% to about 5%, such as 4% or 5%.

The high porosity layer and the low porosity layer may have a similar composition or may have different compositions. Thus in an embodiment the high porosity layer and low porosity layer differ only in their porosity, being formed of the same material. Preferably, however, the high porosity layer and the low porosity layer may differ in composition. In a preferred embodiment the optical multilayer employed in the heterojunctions of the present invention comprises alternate layers of high porosity $SiO_2$ and low porosity $TiO_2$. This combination of materials is preferred due to the large contrast in refractive index which can be obtained using alternating layers of these two materials and structures. High porosity $SiO_2$ having a porosity of 50% has a refractive index of about 1.25 while low porosity $TiO_2$ having a porosity of 5% has a refractive index of about 2.37. However, a range of materials are suitable for use as either the low porosity layer or the high porosity layer in the optical multilayer including, but not limited to, metal oxides, metal halides, metal nitrides, metal carbides, metal chalcogenides, metals, semiconductors, polymers or any mixture thereof. More specifically, the materials forming the layers of the optical multilayer may for instance be selected from among any of the following in amorphous or crystalline form: $SiO_2$, $TiO_2$, $SnO_2$, ZnO, $ZrO_2$, $Nb_2O_5$ $CeO_2$, $Fe_2O_3$, Fe3O4, V2O5, Cr2O3, HfO2, MnO2, Mn2O3, Co3O4, NiO, Al2O3, In2O3, $SnO_2$, CdS, CdSe, ZnS, ZnSe, Ni, Co, Fe, Ag, Au, Se, Si and/or Ge. The materials forming the layers of the optical multilayer may be independently selected in respect of adjacent layers, provided that adjacent layers have a different refractive index.

The high porosity layer and the low porosity layer may comprise or consist of the same material as one another or different materials, as long as the refractive index of the high porosity layer differs from the refractive index of the low porosity layer. Ideally, the low porosity layer will have a refractive index which is higher than the refractive index of the high porosity layer, in order to prevent a potential match in the effective refractive index of the two layers, which would otherwise result in a lack of dielectric constant contrast and therefore prevent a colour effect arising from optical interference Thus, by appropriate selection of the porosity of each layer, the refractive index of that layer can be tuned to give rise to a desired reflectivity profile (reflectance spectrum) of the optical multilayer. For example, $TiO_2$ having a porosity of 50% has a refractive index of 1.72 for 550 nm light while $TiO_2$ having a porosity of 5% has a refractive index of 2.37 for the same wavelength.

It should be noted that optical multilayers according to the present invention would be unsuitable for use in electrolyte cells such as DSCs, since the low porosity of the low porosity layer will hinder or prevent entirely the flow of the electrolyte which is required to maintain electrical contact across the heterojunction. Thus, the optical multilayers described herein are both structurally and functionally different from any 1DPCs used in any conventionally-known dye-sensitised solar cells.

Periodic multilayers such as 1DPCs may be characterised by their lattice parameter. The lattice parameter is the sum of the average thicknesses of the high porosity and low porosity layers. The lattice parameter should therefore not be confused with the overall thickness of the multilayer, since in cases where the multilayer comprises more than one low porosity layer and more than one high porosity layer the overall thickness of the multilayer will be greater than

the lattice parameter. The overall thickness will typically be an integer multiple of the lattice parameter, such as 1, 2, 3, 4 or 5 times the lattice parameter. By choice of materials with a high difference in refractive index, an effective colour-reflecting multilayer can be generated without requiring this multiple to be very high. Thus, an overall thickness which is 1, 2 or 3 times the lattice parameter is preferred, especially an overall thickness which is 2 times the lattice parameter.

Preferably the low porosity layer of the multilayer has an average thickness of about 30 to about 65 nm, e.g. about 35 to about 65 or about 30 to about 60 nm, while the high porosity layer has an average thickness of about 70 to about 120, e.g. about 70 to about 115, about 85 to about 115 or about 85 to about 100 nm. The multilayer thus preferably has a lattice parameter of about 100 to about 185 nm, preferably about 105 to about 180, e.g. about 100 to about 175 nm, 105 to about 145 or about 115 to about 145, e.g. about 120 to about 150 nm.

For layers of the multilayer having a given material composition and a given porosity the refractive index, and thus the wavelength or wavelengths reflected by the multilayer, may be tuned by variation of the lattice parameter. Thus, for example, a multilayer comprising alternating low porosity $TiO_2$ and high porosity $SiO_2$ may be tuned to reflect light in the blue-green region of the visible spectrum when the low porosity layer has an average thickness of about 40 nm and the high porosity layer has an average thickness of about 90 nm giving a lattice parameter of around 130nm. A multilayer comprising alternating low porosity $TiO_2$ and high porosity $SiO_2$ may alternatively be tuned to reflect light in the orange region of the visible spectrum when the low porosity layer has a thickness of about 60 nm and the high porosity layer has a thickness of about 90 nm giving a lattice parameter of around 150nm. Thus it is preferred that a multilayer in accordance with the present invention will comprise a high porosity layer of $SiO_2$ having an average thickness of about 85 to about 95, preferably about 90 nm, and a low porosity layer having an average thickness of about 30 to about 65, preferably about 30 to about 60, about 35 to about 65, about 35 to about 60 or about 40 to about 60 nm, e.g. about 45 to about 55 nm. The lattice parameter of multilayers comprising alternating high porosity $SiO_2$ and low porosity $TiO_2$ layers as described above (e.g. with the layer thicknesses described above) is thus preferably about 115 to about 160 nm, e.g. about 120 to about 150 nm, about 125 to about 150, about 130 to about 145, or about 135 to about 140 nm.

In the case of optical multilayers made by periodic alternation of high and low refractive index materials, the skilled person will be aware of simple formulas which allow estimates to be made of the spectral position of the reflectance peak, the lattice parameter and the refractive indices of the layers (see, for instance "Optical waves in layered media" by Pochi Yeh, chapter 7).

In the case of multilayers comprising $SiO_2$ and $TiO_2$ layers as described above, a lattice parameter of about 120 nm is particularly preferable for achieving a blue reflection, about 130 nm for blue-green, and about 135 nm for green. Where an orange or gold reflecting multilayer is desired, the lattice parameter is desirably about 140 to about 150, preferably about 145 nm. A red reflection can be achieved with a lattice parameter of about 155 to about 165, preferably about 160 nm.

Alternative suitable lattice parameters for layers having different porosities to those mentioned above, and/or comprising materials other than $SiO_2$ and/or $TiO_2$, will readily be determined by the skilled person as required in order to confer the desired reflective properties upon the multilayer.

Preferably the overall thickness of the multilayer is below about 800 nm, particularly preferably below about 500 nm, e.g. about 300 to about 500 nm, particularly preferably about 400 nm or below. For multilayers comprising alternating high porosity $SiO_2$ and low porosity $TiO_2$ layers as described above this typically means that the multilayer will comprise a maximum of 6 layers in total (3 low porosity and 3 high porosity), preferably 4 layers in total (2 low porosity and 2 high porosity).

The multilayer is preferably configured to provide a perceived hue (i.e. reflected wavelength) falling within the colour gamut defined by the following vertices in the CIE 1931 xy chromaticity diagram: (0.27, 0.51), (0.17, 0.42), (0.17, 0.14), (0.22, 0.12), (0.48, 0.34) and (0.46, 0.44). The skilled person will readily be able to determine appropriate combinations of materials, porosities, and layer thicknesses appropriate to provide a given hue falling within the aforementioned gamut. For purposes of comparison, blue-green reflections lie in the region of (0.29, 0.35) and orange reflections in the region of (0.41, 0.40) within the CIE 1931 chromaticity space. For a multilayer comprising a low porosity (high refractive index) material with a porosity of 5% and a high porosity (low refractive index) material with a porosity of 50% the gamut defined above corresponds to a variation in lattice parameter between 20 nm and 300 nm.

Optical multilayers of the type described above thus form a further aspect of the present invention. The present invention therefore provides, for example, an optical multilayer comprising alternate layers of a first material having a first porosity and a second material having a second porosity, wherein the second porosity is higher than the first porosity and the refractive index of the first material is higher than the refractive index of the second material. In an embodiment applicable to all aspects of the invention, the optical multilayer is a one-dimensional photonic crystal (1DPC). A 1DPC may be constructed according to the same principles and parameters outlined above with regard to multilayers in general, with the proviso that the multilayer has a periodic structure.

In a further aspect, the present invention provides a reflector comprising a multilayer as herein described. The multilayer comprised in the reflector of the invention thus preferably consists of two, four or six layers in total wherein adjacent layers comprise materials having alternating porosities and/or refractive indices. In an embodiment the multilayer

comprised in the reflector of the invention is a 1DPC as herein described.

Heterojunctions comprising multilayers as herein described self-evidently form a further aspect of the invention, as does the use of multilayers as herein described in the preparation of a heterojunction. Preferably the heterojunctions are solid-state heterojunctions as herein described.

Preferably, heterojunctions according to the invention will incorporate a multilayer such that a high porosity layer of the multilayer is situated adjacent to the photoactive layer comprising a photoactive perovskite. The photoactive perovskite will at least partially infiltrate pores of the high porosity layer. Example of such infiltration are illustrated by scanning electron microscopy as can be seen in cross-sections of devices such as those illustrated in the Figures Without wishing to be bound by theory, it is believed that this partial infiltration assists in forming a bridging path for charge transport by permitting electrical contact between the perovskite and any compact electron transporting layer which may be present in the heterojunction (e.g. a compact $TiO_2$ layer), while also preserving a high refractive index contrast which gives rise to an intense colour effect clearly perceivable by the naked eye.

References herein to "solid state" heterojunctions refer to heterojunctions not containing a liquid hole-transporting species (electrolyte), e.g. an ionic solution or ionic liquid. As an example, the heterojunction and/or corresponding devices should not contain any iodine/iodide redox couples, such as $I_2/I^{3-}$. The use of the term "electrolyte" is not entirely consistent in the prior art, with some authors using the term "electrolyte" to include non-ionic charge transporting species such as molecular hole transporters. The general convention, however, which is adopted herein, is that the term "electrolyte" refers to a medium through which charge is transported by the movement of ions. Thus, a polymer or gel electrolyte is distinct from the hole transporters (p-type materials) employed in the present invention because the former relies on the movement of ions to carry charge, while the latter conducts by passage of electrons. Thus, the solid state heterojunctions, solar cells and related aspects of the present invention relate to non-electrolyte devices in that they do not contain any "electrolyte" which conducts by ion movement. The heterojunctions and other aspects of the present invention may however contain a solid-state "hole transporter" which conducts electrons.

The term "photoactive" in relation to the perovskite encompasses both light-absorbing and light-emitting perovskites. The layer comprising such photoactive perovskite may therefore also either be light-absorbing or light-emitting.

The term "light-absorbing" in relation to the perovskite (and by extension the layer comprising said perovskite) refers to its role in absorbing light, e.g. visible light, so as to act as a light-absorbing material which converts the light into electrical energy when used in photovoltaic cells, photo-detectors and other such optoelectronic devices whose function is reliant upon the absorption of light, and therefore the perovskite is selected whereby to be capable performing this function.

The term "light-emitting" in relation to the perovskite (and by extension the layer comprising said perovskite) refers to its function as an active light-emitting (e.g. visible-light-emitting) region and thus the term "light-emitting perovskite" may equivalently be employed in order to reflect this purpose.

The terms "photoactive perovskite" and "photoactive layer" will generally be employed throughout this description for consistency and simplicity but it should be understood that this encompasses both light-emitting and light-absorbing perovskites and perovskite-containing layers unless one or the other of these is specifically mentioned, for example depending on the particular nature of any given optoelectronic device incorporating a heterojunction as described herein.

The heterojunctions described herein comprise a photoactive perovskite. Perovskites are materials which adopt a similar crystal structure to calcium titanate and have the general formula $ABX_3$, wherein A and B are cations of differing size, A being larger than B, and X is an anion. In the ideal cubic-symmetry structure, adopted by $CaTiO_3$, the B cation ($Ti^{4+}$) is 6-fold coordinated, surrounded by an octahedron of anions, and the A cation ($Ca^{2+}$) is in 12-fold cuboctahedral coordination. The relative ion size requirements for stability of the cubic structure are quite stringent, so slight buckling and distortion can produce several lower-symmetry distorted versions, in which the coordination numbers of A cations, B cations or both are reduced, producing orthorhombic, tetragonal or trigonal symmetry. For the avoidance of doubt, references to perovskites herein generically refer both to ideal cubic structures as well as lower-symmetry, distorted structures.

Examples of perovskites suitable for use in heterojunctions and optoelectronic devices according to the invention include ammonium trihalogen plumbates such as $CH_3NH_3PbI_3$, $CH_3NH_3PbCl_3$, $CH_3NH_3PbF_3$ and $CH_3NH_3PbBr_3$; mixed-halide ammonium trihalogen plumbate perovskites with general formula $CH_3NH_3Pb[Hal1]_{3-x}[Hal2]_x$ wherein [Hall] and [Hal2] are independently selected from among F, Cl, Br and I with the proviso that [Hall] and [Hal2] are non-identical, and wherein $0 \leq x \leq 3$, preferably wherein x is an integer (e.g. 1, 2 or 3, preferably 1 or 2), preferably wherein [Hall] is I and [Hal2] is Cl; $CsSnX_3$ perovskites wherein X is selected from among F, Cl, Br and I, preferably I; organometal trihalide perovskites with the general formula $(RNH_3)BX_3$ where R is $CH_3$, $C_nH_{2n}$ or $C_nH_{2n+1}$, n is an integer in the range $2 \leq n \leq 10$, preferably $2 \leq n \leq 5$, e.g. n=2, n=3, or n=4, most preferably n=2 or n=3, X is a halogen (F, I, Br or Cl), preferably I, Br or Cl, and B is Pb or Sn; and combinations thereof. Such perovskites as described herein are equally suitable for use either as light-emitting or light-absorbing perovskites in the heterojunctions of the invention.

The perovskites employed in the heterojunctions of the invention are preferably undoped but may if desired be

doped with p-type or n-type dopants. Thus the perovskites referred to herein may be essentially pure semiconductor (e.g. having only unavoidable impurities). Alternatively they may be doped (throughout and/or at the surface) with at least one dopant material of greater valency than the bulk (to provide n-type doping) and/or may be doped with at least one dopant material of lower valency than the bulk (to give p-type doping). n-type doping will tend to increase the n-type character of the semiconductor material while p-type doping will tend to reduce the degree of the natural n-type state (e.g. due to defects).

Such doping may be made with any suitable element including F, Sb, N, Ge, Si, C, In, InO and/or Al. Suitable dopants and doping levels will be evident to those of skill in the art.

While the perovskite can itself function as a hole transporter (hole conductor), it is particularly preferred that the heterojunction further comprises an organic p-type material. The organic p-type material is preferably an organic molecular p-type material such as an organic hole-transporter, preferably a molecular, oligomeric or polymeric organic hole transporter. The terms "hole transporter" and "hole conductor" are employed interchangeably to describe such materials.

In a preferred embodiment, the photoactive perovskite is a compact layer.

All references herein to a "compact" or "planar" layer are interchangeable and are intended to distinguish from "mesoporous" or "meso-superstructured" layers as described in further detail below. Compact layers do not comprise a mesoporous scaffold material.

In an embodiment, the "high porosity" and/or "low porosity" layers of the multilayer may independently be mesoporous, with the high and low porosity layers being distinguished not by pore size but rather according to their overall degree porosity as described above. A mesoporous material is conventionally defined as having pores with diameters in the range 2 nm to 50 nm and that meaning is adopted herein. By way of comparison, other conventional pore size naming conventions include "nanoporous" or "microporous" (pore diameters < 2 nm) and "macroporous" (pore diameters in the range 50 to 1000 nm) and references herein to such terms adopt this conventional meaning. Examples of such definitions may be found, for instance, in J. Rouquerol et al., "Recommendations for the Characterization of Porous Solids", Pure & Appl. Chem., vol. 66, no. 8, pp. 1739-1758, 1994; Sing et al., Pure & Appl. Chem., vol. 57, no. 4, pp. 603-919, 1985; and "Manual on Catalyst Characterization", J. Haber, Pure & Appl. Chem., vol. 63, pp. 1227-1246, 1991.

The general term "porous" is intended to refer to materials having pores on the mesoporous or macroporous level, and therefore "non-porous" layers may nevertheless contain nanopores (micropores), i.e. pores typically having a diameter of 2 nm or less. Compact layers as described herein are normally non-porous. In an embodiment the low porosity layers of the multilayer may be non-porous. A non-porous material as used in any aspect of the invention herein, but especially in relation to the high refractive index material of a multilayer, e.g. a 1DPC, will typically have a porosity of less than 10% of pores of any size, even those of 2nm or less. Preferably, this will be less than 7% , more preferably 2 to 6%.

Compact layers of photoactive perovskite are generally non-porous, as described above. Optionally, however, compact layers of photoactive perovskite may if desired be macroporous or have larger-than-macroporous (i.e. > 1000 nm) pore diameters. Such layers are particularly beneficial for the formation of semitransparent films, for example as described in Eperon et al., ACS Nano, vol. 8, no. 1, pp. 591-598, 2014, the contents of which are hereby incorporated by reference.

References herein to the abbreviations "DSC", "SDSC", "DSSC", "SSC" and any of the foregoing abbreviations prefixed by "ss" may be taken to refer equally to a solid-state dye-sensitized heterojunction device, including referring to an optoelectronic device such as a solar cell or a photo-detector where context allows. Similarly, all references to a heterojunction herein may be taken to refer equally to an optoelectronic device including referring to a solar cell or to a photo-detector where context allows.

While photovoltaic cells are frequently used herein as illustration, it will be appreciated that the heterojunctions of the invention may equally be applied to other corresponding optoelectronic devices including all those described in all sections herein. In particular, the following discussion is generally applicable, amongst other devices, to photovoltaic cells (solar cells), photo-detectors, and light-emitting diodes. In one embodiment the optoelectronic device may be encapsulated. Such encapsulation will be such that the heterojunctions or devices are maintained in the substantial absence of oxygen (particularly molecular oxygen such as atmospheric oxygen). Substantial absence may indicate that the concentration of molecular oxygen within the encapsulation is less than 10%, preferably less than 1% of the concentration in the surrounding atmosphere.

Certain values or parameters may be referred to herein is "about", "around" or "substantially" some value or range of values. Typically this is used to represent a value of up to 10% greater or less than the specified value. More preferably this will represent the value $\pm$ 5% or more preferably $\pm$ 2%. The exact value specified evidently forms a preferred embodiment.

The n-type layer preferably comprises a transparent, electrically-conductive metal oxide selected from among $TiO_2$ (also referred to as "titania"), ZnO, $SnO_2$, Niobium oxide (NbO, $NbO_2$, $Nb_2O_5$), nickel (II) oxide (NiO), $W_2O_3$, $MoO_3$,

$ZrO_2$, Indium Oxide, Indium Oxide Tin Oxide (ITO), and Fluorine Doped Tin Oxide (FTO). $TiO_2$ is preferred. In addition to the rutile, anatase and brookite crystal structures, $TiO_2$ has three known metastable phases which can be produced synthetically (monoclinic, tetragonal and orthorhombic), and five high-pressure forms ($\alpha$-$PbO_2$-like, baddeleyite-like, cotunnite-like, orthorhombic, and cubic phases) also exist. For use in the heterojunctions of the present invention, $TiO_2$ having any phase structure may be used. The anatase structure is particularly preferred. In particular, a compact layer of $TiO_2$ is preferred for use as the n-type layer.

Inorganic sulfides may also be suitable for formation of n-type layers. Suitable sulfides include CdS, ZnS and zinc oxysulfide ($ZnO_xS_{1-x}$).

The n-type layer is preferably a compact layer.

It is particularly preferred that the heterojunction further comprises a p-type material distinct from the perovskite layer. The p-type material (also referred to as a hole transporter or hole conductor) is preferably an organic p-type material. Suitable organic p-type materials will typically comprise an extended pi-bonding system through which charge may readily pass. Suitable materials will also preferably be amorphous or substantially amorphous solids rather than being crystalline at the appropriate working temperatures (e.g. around 30-70°C). The organic hole-transporter would preferably have a high energy HOMO to LUMO transition, rendering its predominant function dye-regeneration and hole-transport. However, it may optionally have a narrow HOMO to LUMO transition, with its additional function being to absorb solar light, thereby functioning as a light absorber in addition to the light-absorbing perovskite. Preferably the organic hole-transported has a high energy HOMO to LUMO transition and does not absorb solar light.

According to a preferred embodiment, the solid state hole transporter is a material comprising a structure according to any of formulae (tI), (tII), (tIII), (tIV) and/or (tV) below:

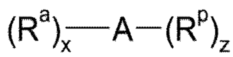
(tI);

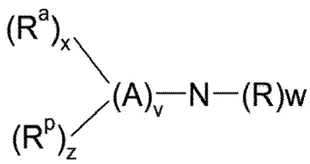
(tII);

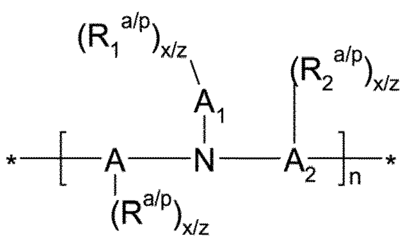

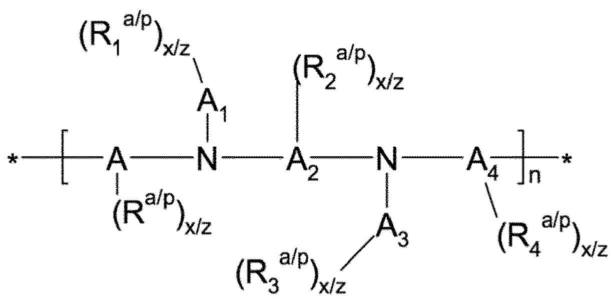

(tIII);

(tIV) ;

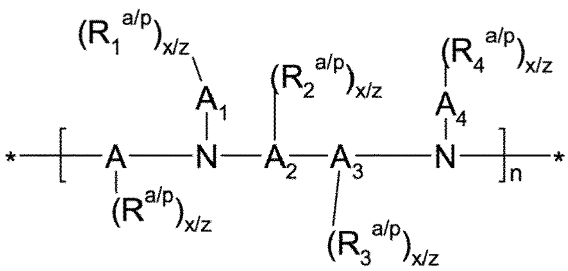
(tV)

in which N, if present, is a nitrogen atom;

n, if applicable, is in the range of 1-20;

A is a mono-, or polycyclic system comprising at least one pair of a conjugated double bond (-C=C-C=C-), the cyclic system optionally comprising one or several heteroatoms, and optionally being substituted, whereby in a compound comprising several structures A, each A may be selected independently from another A present in the same structure (tII - tV);

each of A1-A4, if present, is an A independently selected from the A as defined above; v in (tII) recites the number of cyclic systems A linked by a single bond to the nitrogen atom and is 1, 2 or 3;

(R)w is an optional residue selected from a hydrocarbon residue comprising from 1 to 30 carbon atoms, optionally substituted and optionally comprising 1 or several heteroatoms, with w being 0, 1 or 2 provided that v + w does not exceed 3, and, if w = 2, the respective Rw1 or Rw2 being the same or different;

$R^a$ represents a residue capable, optionally together with other $R^a$ present on the same structure (tI-tV), of decreasing the melting point of an organic compound and is selected from a linear, branched or cyclic alkyl or a residue comprising one or several oxygen atoms, wherein the alkyl or the oxygen comprising residue is optionally halogenated;

x is the number of independently selected residues $R^a$ linked to an A and is selected from 0 to a maximum possible number of substituents of a respective A, independently from the number x of other residues $R^a$ linked to another A optionally present;

with the proviso that per structure (tI-tV) there is at least one $R^a$ being an oxygen-containing residue as defined above; and, if several $R^a$ are present on the same structure (I-V), they are the same or different; and wherein two or more $R^a$ may form an oxygen-containing ring;

$R^p$ represents an optional residue enabling a polymerisation reaction with compounds comprising structure (tI - tV) used as monomers, and/or a cross-linking between different compounds comprising structures (tI - tV);

z is the number of residues $R^p$ linked to an A and is 0, 1, and/or 2, independently from the number z of other residues $R^p$ linked to another A optionally present;

$R^p$ may be linked to an N-atom, to an A and/or to a substituent $R^p$ of other structures according (tI - tV), resulting in repeated, cross-linked and/or polymerised moieties of (tI - tV);

$(R^{a/p})_{x/z}$ and $(R_{1-4}{}^{a/p})_{x/z}$, if present, represent independently selected residues Ra and Rp as defined above.

Preferably, the charge transporting material comprises compounds having the structures (tI) - (tV).

General reference to the several structures, such as in the references "(tI-tV)", "(tVII-tXVI)", or "A1-A4", for example, means reference to any one selected amongst (tI), (tII), (tIII), (tIV), or (tV), any one selected amongst (tVII), (tVIII), (tIX), (tX), (tXI), (tXII), (tXIII), (tXIV), (tXV) or (tXVI), or any one selected amongst A1, A2, A3 or A4, respectively. In addition, in the charge transporting material for use in the invention, for example, different compounds of structures (tI-tV) may be combined and, if desired cross-linked and/or polymerised. Similarly, in any structure (tI-tV), different structures for A may be selected independently, for example from (tVII-tXVI).

According to a preferred embodiment, the organic charge transporting material of the device of the invention comprises a structure according to formula (tVI):

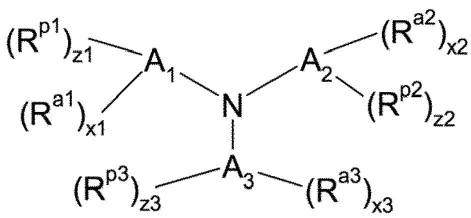

(tVI)

in which $R^{a1}$, $R^{a2}$ and $R^{a3}$ and x1, x2 and x3 are defined, independently, like $R^a$ and x, respectively, above; $R^{p1}$, $R^{p2}$ and $R^{p3}$ and z1, z2 and z3 are defined, independently, like Rp and z, respectively, above. Formula (tVI) thus represents a specimen of formula (tII) above, in which v is 3, and in which R(w) is absent.

Preferably, A is a mono- or polycyclic, optionally substituted aromatic system, optionally comprising one or several heteroatoms. Preferably, A is mono-, bi- or tricyclic, more preferably mono-, or bicyclic. Preferably, if one or more heteroatoms are present, they are independently selected from O, S, P, and/or N, more preferably from S, P and/or N, most preferably they are N-atoms.

According to a preferred embodiment, A is selected from benzol, naphthalene, indene, fluorene, phenanthrene, anthracene, triphenylene, pyrene, pentalene, perylene, indene, azulene, heptalene, biphenylene, indacene, phenalene, acenaphtene, fluoranthene, and heterocyclic compounds such as pyridine, pyrimidine, pyridazine, quinolizidine, quinoline, isoquinoline, quinoxaline, phtalazine, naphthyridine, quinazoline, cinnoline, pteridine, indolizine, indole, isoindole, carbazole, carboline, acridine, phenanthridine, 1,10-phenanthroline, thiophene, thianthrene, oxanthrene, and derivatives thereof, each of which may optionally be substituted.

According to a preferred embodiment, A is selected from structures of formula (tVII-tXIV) given below:

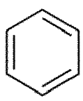 (tVII) 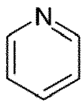 (tVIII) 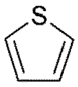 (tIX) 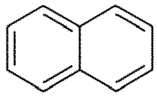 (tX) 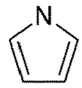 (tXI)

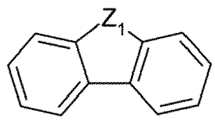 (tXII) 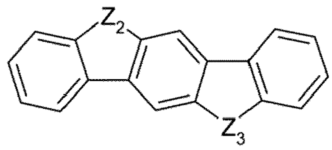 (tXIII)

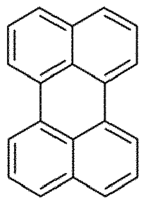 (tXIV) 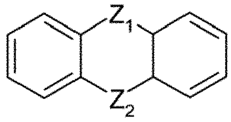 (tXV) ;

in which each of $Z_1$, $Z_2$ and $Z_3$ is the same or different and is selected from the group consisting of O, S, SO, $SO_2$, NR1, N+(R1')(1''), C(R2)(R3), Si(R2')(R3') and P(O)(OR4), wherein R1, R1' and R1'' are the same or different and each is selected from the group consisting of hydrogen atoms, alkyl groups, haloalkyl groups, alkoxy groups, alkoxyalkyl groups, aryl groups, aryloxy groups, and aralkyl groups, which are substituted with at least one group of formula -N+(R5)3 wherein each group R5 is the same or different and is selected from the group consisting of hydrogen atoms, alkyl groups and aryl groups, R2, R3, R2' and R3' are the same or different and each is selected from the group consisting of hydrogen atoms, alkyl groups, haloalkyl groups, alkoxy groups, halogen atoms, nitro groups, cyano groups, alkoxyalkyl groups, aryl groups, aryloxy groups and aralkyl groups or R2 and R3 together with the carbon atom to which they are attached represent a carbonyl group, and R4 is selected from the group consisting of hydrogen atoms, alkyl groups, haloalkyl groups, alkoxyalkyl groups, aryl groups, aryloxy groups and aralkyl groups.

Preferred embodiments of, structure (tXV) for A may be selected from structures (tXVI) and (tXVIa) below:

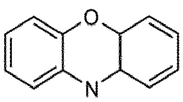 (tXVI), 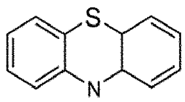 (tXVIa).

Preferably, in any structure of (tI-tV) all A are the same, but differently substituted. For example, all A are the same, some of which may be substituted and some of which are not. Preferably, all A are the same and identically substituted.

Any A may be substituted by other substituents than $R^a$ and/or $R^p$. Other substituents may be selected at the choice of the skilled person and no specific requirements are indicated herein with respect to them. Other substituents may thus correspond to (R)w in (tII) defined above. Other substituents and R(w) may generally be selected from linear, branched or cyclic hydrocarbon residues comprising from 1 to 30 carbon atoms, optionally substituted and optionally comprising 1 or several heteroatoms, for example. The hydrocarbon may comprise C-C single, double or triple bonds. For example, it may comprise conjugated double bonds. For example, optional other residues on A may be substituted with halogens, preferably -F and/or -Cl, with -CN or $-NO_2$, for example.

One or more carbon atoms of other substituents of A may or may not be replaced by any heteroatom and/or group selected from the group of -O-, -C(O)-, -C(O)O-, -S-, S(O)-, $SO_2$-, $S(O)_2O$-, -N=, -P=, -NR'-, -PR'-, -P(O)(OR')-, -P(O)(OR')O-, P(O)(NR'R')-, -P(O)(NR'R')O-, P(O)(NR'R')NR'-, -S(O)NR'-, and $-S(O)_2NR'$, with R' being H, a $C_1$-$C_6$ alkyl, optionally partially halogenated.

According to a preferred embodiment, any A may optionally be substituted with one or several substituents independently selected from nitro, cyano, amino groups, and/or substituents selected from alkyl, alkenyl, alkynyl, haloalkyl, alkoxy, and alkoxyalkyl groups, including substituted substituents. Alkyl, alkenyl, alkynyl, haloalkyl, alkoxy and alkoxyalkyl are as defined below.

Preferably, further residues optionally present on A, such as R(w) in (tII), for example, are selected from $C_4$-$C_{30}$

alkenes comprising two or more conjugated double bonds.

$R^a$ may be used as a residue capable of controlling the melting point of an organic, charge-transporting compound. The reference with respect to the ability to control the melting point is the same charge transporting material devoid of the at least one residue $R^a$. In particular, the function of $R^a$ is to provide a charge transporting material that adopts the desired phase at the temperatures indicated herein. The adjustment of the melting point to obtain the desired characteristics in the temperature ranges indicated above may be brought about by a single residue $R^a$ or a combination of identical or different residues Ra, present in any of the structures (tI)-(tV).

At least one linear, branched or cyclic residue containing one or several oxygen atoms may be used for lowering the melting point, and thus the absence of such residues or alternative residues may be used to correspondingly raise melting points, thus obtaining the desired characteristics. Other residues, include for example alkyls as defined below, may assist in the adjustment of the melting point and/or phase characteristics.

$R^a$ may be halogenated and/or perhalogenated in that one, several or all H of the residue $R^a$ may be replaced with halogens. Preferably, the halogen is fluorine.

If $R^a$ is oxygen containing compound, it is preferably a linear, branched, or cyclic saturated $C_1$-$C_{30}$ hydrocarbon comprising 1 - 15 oxygen atoms, with the proviso that the number of oxygen atoms does preferably not exceed the number of carbons. Preferably, $R^a$ comprises at least 1.1 to 2 as much carbon as oxygen atoms. Preferably, $R^a$ is a $C_2$ - $C_{20}$, saturated hydrocarbon comprising 2-10 oxygen atoms, more preferably a $C_3$-$C_{10}$ saturated hydrocarbon comprising 3-6 oxygen atoms.

Preferably, $R^a$ is linear or branched. More preferably $R^a$ is linear.

Preferably, $R^a$ is selected from a $C_1$-$C_{30}$, preferably $C_2$-$C_{15}$ and most preferably a $C_3$-$C_8$ alkoxy, alkoxyalkyl, alkoxyalkoxy, alkylalkoxy group as defined below.

Examples of residues $R^a$ may independently be selected from the following structures:

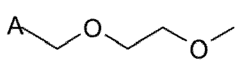 , 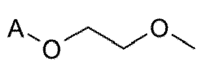 , 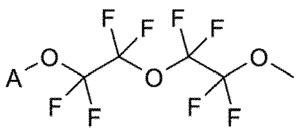 , 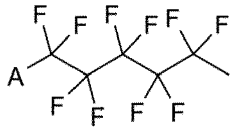 .

with A indicating any A in formula (tI-V) above.

Any $R^a$ present may be linked to a carbon atom or a heteroatom optionally present in A. If $R^a$ is linked to a heteroatom, it is preferably linked to a N-atom. Preferably, however, any $R^a$ is linked to a carbon atom. Within the same structure (tI-tV), any $R^a$ may be linked to a C or a heteroatom independently of another $R^a$ present on the same A or in the same structure.

Preferably, every structure A, such as A, A1, A2, A3 and A4, if present in formulae (tI-tV) above comprises at least one residue Ra. For example, in the compound according to structure (tI-tV), at least one structure A comprises an oxygen containing residues Ra as defined above, whereas one or more other and/or the same A of the same compound comprise an aliphatic residue Ra, for example an alkyl group as defined below, preferably a $C_2$-$C_{20}$, more preferably $C_3$-$C_{15}$ alkyl, preferably linear.

The following definitions of residues are given with respect to all reference, to the respective residue, in addition to preferred definitions optionally given elsewhere. These apply specifically to the formulae relating to hole transporters (tN formulae) but may optionally also be applied to all other formulae herein where this does not conflict with other definitions provided.

An alkoxyalkoxy group above is an alkoxy group as defined below, which is substituted with one or several alkoxy groups as defined below, whereby any substituting alkoxy groups may be substituted with one or more alkoxy groups, provided that the total number of 30 carbons is not exceeded.

An alkoxy group is a linear, branched or cyclic alkoxy group having from 1 to 30, preferably 2 to 20, more preferably 3-10 carbon atoms.

An alkoxyalkyl group is an alkyl group as defined below substituted with an alkoxy group as defined above.

An alkyl group is a linear, branched and/or cyclic having from 1-30, preferably 2-20, more preferably 3-10, most preferably 4-8 carbon atoms. An alkenyl groups is linear or branched $C_2$-$C_{30}$, preferably $C_2$-$C_{20}$, more preferably $C_3$-$C_{10}$ alkenyl group. An alkynyl group is a linear or branched $C_2$-$C_{30}$, preferably $C_2$-$C_{20}$, more preferably $C_3$-$C_{10}$ linear or branched alkynyl group. In the case that the unsaturated residue, alkenyl or alkynyl has only 2 carbons, it is not branched.

A haloalkyl groups above is an alkyl groups as defined above which is substituted with at least one halogen atom.

An alkylalkoxy group is an alkoxy group as defined above substituted with at least one alkyl group as defined above, provided that the total number of 30 carbons is not exceeded.

The aryl group above and the aryl moiety of the aralkyl groups (which have from 1 to 20 carbon atoms in the alkyl moiety) and the aryloxy groups above is an aromatic hydrocarbon group having from 6 to 14 carbon atoms in one

or more rings which may optionally be substituted with at least one substituent selected from the group consisting of nitro groups, cyano groups, amino groups, alkyl groups as defined above, haloalkyl groups as defined above, alkoxyalkyl groups as defined above and alkoxy groups as defined above.

The organic charge transporting material may comprise a residue $R^p$ linked to an A. According to a preferred embodiment, $R^p$ is selected from vinyl, allyl, ethynyl, independently from any other $R^p$ optionally present on the A to which it is linked or optionally present on a different A within the structures (tI) and/or (tII).

The charge transporting material comprised in the devices of the invention may be selected from compounds corresponding to the structures of formulae (tI-tV) as such. In this case, n, if applicable, is 1 and the charge transporting material comprises individual compounds of formulae (tI-tV), or mixtures comprising two or more different compounds according formulae (tI-tV).

The compounds of structures (tI-tV) may also be coupled (e.g. dimerised), oligomerised, polymerized and/or cross-linked. This may, for example, be mediated by the residue Rp optionally present on any of the structures (tI-tV). As a result, oligomers and/or polymers of a given compound selected from (tI-tV) or mixtures of different compounds selected from structures (tI-tV) may be obtained to form a charge transporting material. Small n is preferably in the range of 2-10.

A particularly preferred organic molecular hole transporter contains a spiro group to retard crystallisation. A most preferred organic hole transporter is a compound of formula tXVII below, and is described in detail in Snaith et al. Applied Physics Letters 89 262114 (2006), which is herein incorporated by reference.

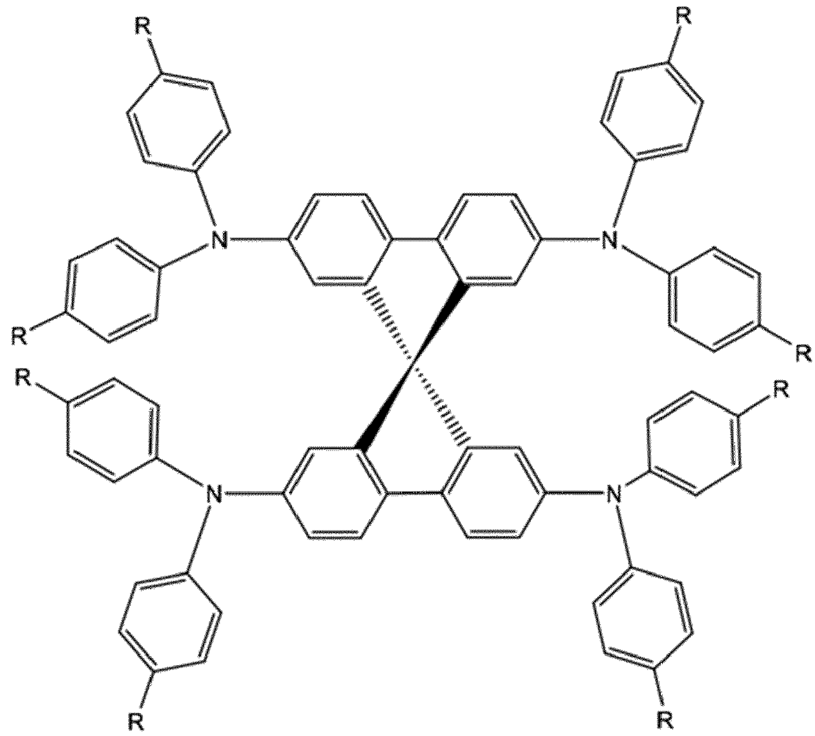

Formula tXVII

wherein R is alkyl or O-alkyl, where the alkyl group is preferably methyl, ethyl, n-propyl, iso-propyl, n-butyl, sec-butyl or tert-butyl, preferably methyl.

Particularly effective examples of conducting polymers include poly(3-hexylthiophene) (P3HT), poly[2-methoxy-5-(3,7- dimethyloctyloxy)]-1 ,4-phenylenevinylene) (MDMO-PPV), poly(2,5-bis(3- alkylthiophen-2-yl)thieno[3,2-b]thiophene), and poly[(9,9-dioctylfluorenyl-2,7-diyl)- alt-5,5-(40,70-di-2-thienyl-20,10,30-benzothiadiazole)] (APFO-3). PEDOT:PSS (a mixture of poly(3,4-ethylenedioxythiophene) and polystyrene sulfonate) is also particularly effective. Particularly preferred organic p-type materials for use in heterojunctions described herein are Spiro-OMeTAD and P3HT. Examples of low band gap polymers include poly[2,6-(4,4-bis-(2-ethylhexyl)-4H-cyclopenta[2,1 -b;3,4-b0] dithiophene)-alt-4,7-(2,1 ,3-benzothiadia-zole)] (PCPDTBT), APFO-Green5.

Where the photoactive perovskite is a light absorbing perovskite, the light absorbing perovskite material and optionally the p-type material are selected whereby to be capable of absorbing light, e.g. visible light, so as to act as a sensitizer. Preferably no additional sensitizing agent is employed.

While it is preferred that the light-absorbing perovskite is the only light-absorbing component present in the heterojunctions of the invention, or optionally the light-absorbing perovskite and p-type material are the sole light-absorbing components, it is also contemplated that in certain embodiments the heterojunction may further comprise one or more additional sensitizing agents (equivalently referred to as sensitizers or light absorbers).

Where present, the additional sensitizing agent(s) may be one or more dyes or any material which generates an electronic excitation as a result of photon absorption and which is capable of electron injection into the n-type material and/or, preferably, the organic electron absorbing material. The most commonly used light sensitising materials in electrolytic DSCs, which are also suitable for use in the solid-state heterojunctions described herein, are organic or metal-complexed dyes. These have been widely reported in the art and the skilled worker will be aware of many existing sensitizers, all of which are suitable in all appropriate aspects of the invention. Common categories of organic dye sensitizers are indolene based dyes, which are discussed, for example, in Horiuchi et al. J Am. Chem. Soc. 126 12218-12219 (2004), which is hereby incorporated by reference; ruthenium metal complexes, particularly those having two bipyridyl coordinating moieties, which are discussed in many published documents including, for example, Kuang et al. Nano Letters 6 769-773 (2006), Snaith et al. Angew. Chem. Int. Ed. 44 6413-6417 (2005), Wang et al. Nature Materials 2, 402-498 (2003), Kuang et al. Inorganica Chimica Acta 361 699-706 (2008), and Snaith et al. J Phys, Chem. Lett. 112 7562-7566 (2008), the disclosures of which are hereby incorporated herein by reference, as are the disclosures of all material cited therein; Metal-Phthalocyanine complexes such as zinc phthalocyanine PCH001, the synthesis and structure of which is described by Reddy et al. (Angew. Chem. Int. Ed. 46 373-376 (2007)), the complete disclosure of which (particularly with reference to Scheme 1), is hereby incorporated by reference; Metal-Porphyrin complexes, Squaraine dyes, Thiophene based dyes, fluorene based dyes, molecular dyes and polymer dyes. Examples of Squaraine dyes may be found, for example in Burke et al., Chem. Commun. 2007, 234, and examples of polyfluorene and polythiothene polymers in McNeill et al., Appl. Phys. Lett. 2007, 90, both of which are incorporated herein by reference.

The n- and p-type materials employed in the heterojunctions described herein may be essentially pure semiconductor (e.g. having only unavoidable impurities). Alternatively they may be doped (throughout and/or at the surface) with at least one dopant material of greater valency than the bulk (to provide n-type doping) and/or may be doped with at least one dopant material of lower valency than the bulk (to give p-type doping). n-type doping will tend to increase the n-type character of the semiconductor material while p-type doping will tend to reduce the degree of the natural n-type state (e.g. due to defects). Such doping may be performed, for example, in order to optimise the function of the heterojunction device, for example by increasing or reducing the conductivity of the n-type layer or p-type layer or by matching the conduction band in the n-type layer or p-type layer to the conduction band of the perovskite.

Such doping may be made with any suitable element including F, Sb, N, Ge, Si, C, In, InO and/or Al. Suitable dopants and doping levels will be evident to those of skill in the art.

The thickness of the photoactive perovskite layer (also referred to as a film) should be chosen to optimize the device performance. Where the photoactive perovskite layer is a light-absorbing perovskite layer, if the film is too thin, then that region will not absorb sufficient sunlight. If the film is too thick, there is a significant chance that the electron and hole (or exciton) diffusion length will be shorter than the film thickness and that the charge will therefore not be collected efficiently.

For optimal performance it is particularly preferred that the perovskite layer is of substantially uniform thickness. In one embodiment, that thickness in a heterojunction may be less than the charge transfer distance of the perovskite selected for forming that heterojunction.

For planar (i.e. compact) perovskite layers the thickness of the photoactive perovskite layer is therefore preferably in the range 50 to 500 nm, e.g. 100 to 450 nm, 100 to 400 nm or 100 to 350 nm. A thickness of 200 to 350 nm, e.g. 300 nm, is particularly preferred. In one preferred embodiment, the compact perovskite layer does not exceed 330 nm in thickness.

Where an organic hole-transporting (p-type) material is employed this may be provided as an additional discrete layer, e.g. a layer situated adjacent to and in contact with the perovskite layer. Alternatively, where the perovskite layer is mesoporous, the organic p-type material may at least partially infiltrate the mesoporous perovskite.

Preferably the n-type or p-type layer in the heterojunctions of the invention has a thickness of $\leq$500 nm, preferably $\leq$ 350 nm, e.g. $\leq$ 150 nm or $\leq$ 100 nm. A thickness of 30 to 80 nm (e.g. 50 nm), or 50 to 100 nm is particularly preferred.

In order to allow the usage of the heterojunctions of the invention in optoelectronic devices, the heterojunction will typically further comprise a cathode. The cathode is preferably metallic, such as a silver or gold cathode or a cathode comprising silver or gold or a mixture thereof.

Where a metallic cathode is provided, it has been found that the efficiency of heterojunctions can be adversely affected, for example with the efficiency experiencing a significant decline as operational time increases. This may occur particularly when the heterojunction is present in a device which is encapsulated and thus at least partially separated from atmospheric oxygen (which is an optional feature of all devices described herein). Without wishing to be bound by theory, it is believed that shunting pathways arise, during operation, from the migration of metallic contacts, e.g. through the organic p-type hole transporting material (HTM) where this is present. It has been found that the use of a permeable protective buffer ("barrier") layer of an insulating material interposed between the cathode and the perovskite (such as at least partially permeating the organic p-type material, where this is present) not only avoids such shunting pathways

from developing but also leads to a further improvement in fill factor and photoconversion efficiency. Suitable barrier layers are permeable, e.g. porous, preferably mesoporous.

Thus in one embodiment the present invention provides a solid-state heterojunction as herein described wherein a permeable barrier layer comprising at least one insulating material is located adjacent to a cathode.

All references herein to a "permeable barrier layer", "insulating layer", "insulating barrier layer", "permeable layer" or the like may be taken to refer equally to a permeable barrier layer comprising at least one insulating material.

Permeable barrier layers as described herein may have other additional properties, such as being highly moisture absorbent, or able to absorb other gases such as oxygen or halide ions. As such it could additionally act as a "getter" in order to enhance the long term stability of the solar cells. Materials with such properties include nanozeolites, for example microcrystalline alumina silicate. Such materials are a further preferable material for use as the permeable barrier layer.

Suitable nanozeolites include, for example, LTA or LTL type zeolites. These may suitably be deposited by spin coating, e.g. prior to deposition of a hole transporting material. Such embodiments protect the perovskite not only from the shunting of the electrode but also from water molecules which infiltrate through a hole transporter (especially where the hole transporter is spiro-OMeTAD) in the presence of a humid environment.

Insulating polymers, either alone or in combination with each other or with other materials are also highly suitable materials for forming a permeable barrier layer. Examples of suitable polymers include: polystyrene, acrylate, methacrylate, methylmethacrylate, ethylene oxide, ethylene glycol, cellulose and/or imide polymers or mixtures thereof.

Block copolymers are a subset of insulating polymers which are highly suitable either alone or in combination with each other, with other polymers and/or with other materials. Examples of suitable block copolymers include: polyisoprene-block-polystyrene, poly(ethylene glycol)-block-poly(propylene glycol)-block-poly(ethylene glycol), polystyrene-block-polylactide, and/or polystyrene-block-poly(ethylene oxide) or mixtures thereof.

The thickness of the insulating barrier layer should be sufficient to provide an insulating effect without being so thick that a significant increase in the internal resistance is caused. Suitable thicknesses will be readily established by those of ordinary skill depending upon the barrier material, the porosity and the nature of the hole transporter. In a preferred embodiment, the permeable barrier layer has a thickness of 1 to 1000 nm, preferably less than 500 nm, e.g. 450 nm or less, 400 nm or less, 350 nm or less, 300 nm or less, 250 nm or less, 200 nm or less, 150 nm or less, 100 nm or less, or 50 nm or less. Barrier layer thicknesses of 50 to 200 nm are particularly preferred, especially 50 to 150 nm, e.g. 80 to 140 nm, particularly 100 to 130 nm.

The porosity of the insulating barrier layer should be such as to allow this to be impregnated with the hole transporter with a sufficient degree of penetration that a reliable conduction path from the point of charge separation to the cathode is provided. Examples of suitable porosities range from 10 to 90%, preferably 25 to 75%, more preferably 40 to 60%.

The material for forming the insulating barrier layer should evidently have a low conductivity and thus high resistivity. A suitable conductivity will be established by routine testing by one of skill in the art, such that the resulting device is effective and capable of encapsulation without any significant light-induced drop in shunt resistance. Typically, however, a suitable insulator will have a conductivity of less than $10^{-9}$ S $cm^{-1}$. Correspondingly, a suitable insulator will typically have a resistivity of greater than $10^9$ $\Omega$cm. Conductivity and/or resistivity may be measured by standard techniques, such as by a 4 point probe conductivity measurement, as described in S. M. Sze in "Semiconductor Devices Physics and Technology", 2nd Edition, Wiley Page 54.

A dispersion of $Al_2O_3$ nanoparticles in isopropanol has been found to be a particularly suitable material for formation of such a buffer layer of insulating material.

Preferably, the perovskite and the cathode are separated by a distance of no less than 1 nm at their closest point, by said barrier layer. The said barrier layer will cover substantially the whole of the area between the cathode and the anode. For example, the barrier layer may cover at least 95%, preferably at least 99% and most preferably at least 99.9% of the area of overlap between the perovskite layer and the cathode. In one embodiment, the permeable barrier layer is a substantially continuous capping layer, e.g a layer extending over substantially all of the perovskite layer.

Optionally, the insulating material may be provided in the form of solid particles dispersed in the organic p-type material, where this is present. Preferably such particles are nanoparticles having a particle size of 1 to 100 nm.

The buffer layer is optionally a substantially continuous capping layer as described herein. Alternatively, the buffer layer may be provided in the form of nanoparticles which are dispersed in any organic p-type material which is present. Such nanoparticles may suitably be deposited by spin-coating together with the p-type material, for example.

Where an organic p-type material is present, the permeable barrier layer of insulating material should preferably be sufficiently porous so as to permit a conduction path from the perovskite and/or n-type material to the cathode by means of the p-type material (hole transporter) but sufficiently insulating to prevent electrical contact (i.e. direct charge transfer) between the cathode and the perovskite and/or n-type material. Similarly, the barrier layer should be sufficiently thick to reliably insulate the perovskite from the cathode but should not be thicker than necessary due to the increase in resistance caused by a longer path of conduction through the hole transporter.

In this respect, it will be preferable that the porous barrier layer is formed from at least one insulating material with a resistivity of greater than $10^9$ Ωm. Suitable barrier layers are described in detail herein.
It is particularly preferable that the insulating barrier layer has a porosity of 10 to 90%.
Preferably, the insulating material used in the heterojunctions described herein comprises at least one insulating metal oxide, either alone or in combination with other metal salts. Suitable insulating metal oxides may for example be selected from $Al_2O_3$ $SiO_2$, ZrO, MgO, $HfO_2$, $Ta_2O_5$, $Nb_2O_5$ $Nd_2O_3$, $Sm_2O_3$, $La_2O_3$, $Sc_2O_3$, $Y_2O_3$, NiO, $MoO_3$, MnO, $SiAlO_{3,5}$, $Si_2AlO_{5,5}$, $SiTiO_4$, $AlTiO_5$, zeolites, and mixtures thereof. Particularly preferably, the insulating metal oxide is $Al_2O_3$.
The step of forming an insulating barrier layer may be performed by any method suitable for generating a porous insulating layer from the material to be employed. Such methods include formation of a polymeric porous sheet and placing that between the n-type material and the cathode, depositing the material by evaporation, spraying (e.g. spray pyrolysis) or sputter deposition, or by forming a paste of insulating particles, followed by heating/sintering.
In one embodiment, any of the heterojunctions or optoelectronic devices (e.g. solar cells) of the present invention may be encapsulated. Such encapsulation will be such that the heterojunctions or devices are maintained in the substantial absence of oxygen (particularly molecular oxygen such as atmospheric oxygen). Substantial absence may indicate that the concentration of molecular oxygen within the encapsulation is less than 10%, preferably less than 1% of the concentration in the surrounding atmosphere.
Typically heterojunctions such as those described therein will be fabricated on a glass substrate which serves both to assist in encapsulation and to allow transmission of light to/from the heterojunction. FTO (fluorine-tin-oxide) coated glass substrates are particularly preferred as the FTO coating may function as an anode.
Thus in one embodiment the present invention provides a solid-state heterojunction comprising the following layers:

(i) a cathode (preferably a metal, metallic, or transparent conducting oxide cathode);
(ii) optionally a permeable barrier layer of insulating material;
(iii) a p-type layer, preferably comprising an organic p-type material;
(iv) a photoactive perovskite layer;
(v) an optical multilayer;
(vi) an n-type layer;
(vii) an FTO-coated glass substrate.

In the above embodiment the order in which the layers (i) to (vii) above are listed reflects their order in the heterojunction. Each layer is as herein described. In particular, layers (ii) and (iii) are optional and, where both are present, layer (iii) preferably at least partially infiltrates layer (ii). Layers (iii), (iv) and (vi) are each independently of one another optionally compact or meso-superstructured. Preferably layer (iv) is compact. In a preferred embodiment layer (v) is a one-dimensional photonic crystal (1DPC) as herein described. In the solid-state heterojunctions herein described the FTO coating on the glass substrate may act as a transparent conducting oxide anode.
In a further embodiment the present invention provides a solid-state inverted heterojunction comprising the following layers:

(i) an anode (preferably a metal, metallic, or transparent conducting oxide anode);
(ii) an n-type layer;
(iii) a photoactive perovskite layer;
(iv) an optical multilayer;
(v) optionally a p-type layer, preferably comprising an organic p-type material;
(vi) an FTO-coated glass substrate.

In the above embodiment the order in which the layers (i) to (vi) above are listed reflects their order in the heterojunction. Each layer is as herein described. In particular, layer (v) is optional. Layers (ii), (iii) and (v) are each independently of one another optionally compact or meso-superstructured. Preferably layer (iii) is compact. In a preferred embodiment layer (iv) is a one-dimensional photonic crystal (1DPC) as herein described. In the solid-state inverted heterojunctions herein described the FTO coating on the glass substrate may act as a transparent conducting oxide cathode. Optionally "inverted" heterojunctions may comprise a permeable barrier layer of insulating material as herein described, for instance located between the n-type material and the perovskite.
In the hetereojunctions and inverted heterojunctions herein described, the optical multilayer (such as a 1DPC) of the invention is employed in a different configuration to conventional 1DPC-containing heterojunctions such as dye-sensitized solar cells (DSCs). Conventional 1DPC-containing heterojunctions such as DSCs typically employ the photonic multilayer as a back reflector, in order to avoid a large drop in power conversion efficiency which would otherwise result

(e.g. from the optical multilayer hindering charge transport in the liquid electrolyte). In contrast, in the heterojunctions of the present invention, due to the particularly high optical absorption of the perovskite layer, it is possible to place the optical multilayer in front of the photoactive layer, i.e. in between the photoactive perovskite layer and the glass substrate, such that incident light encounters the optical multilayer before encountering the photoactive perovskite layer, without adversely affecting the operation of the device.

In a further embodiment the present invention provides a solid-state heterojunction having at least one of the following:

(i) an open-circuit voltage ($V_{OC}$) of at least 0.9 V
(ii) a short-circuit current ($J_{SC}$) of at least 7 $mAcm^{-2}$
(iii) a fill factor (FF) of at least 0.6
(iv) an energy conversion efficiency ($\eta$) of at least 4%;
(v) a colour hue comprised within the colour gamut defined by the following vertices in the CIE 1931 xy chromaticity diagram: (0.27, 0.51), (0.17, 0.42), (0.17, 0.14), (0.22, 0.12), (0.48, 0.34) and (0.46, 0.44),

when measured under simulated AM 1.5 100m $Wcm^{-2}$ sunlight.

Optoelectronic devices comprising at least one heterojunction as herein described also self-evidently form part of the present invention. Thus in one embodiment the invention provides an optoelectronic device comprising at least one solid-state heterojunction as herein described. In particular, such an optoelectronic device may be a solar cell or photo-detector. In a further embodiment, the optoelectronic device of the invention may be a light-emitting diode (LED). The optoelectronic device of the invention is preferably encapsulated. In one embodiment, the optoelectronic device of the invention may comprise a solid-state heterojunction as herein described as the top cell in a tandem junction. In a further embodiment, the optoelectronic device of the invention may comprise a solid-state heterojunction as herein described as the top cell in a multiple junction and a further solid-state heterojunction as herein described as the bottom cell in said multiple junction.

In one preferred embodiment, the optoelectronic devices of the present invention may be in the form of construction materials. Thus, the invention additionally comprises a construction material comprising at least one optoelectronic device of the present invention. Such construction materials may be used for surfacing or cladding, such as on a building. Thus the construction material may be formed in a size and shape suitable for such a use. Typically this will be a planar or curved sheet at least 30cm in two dimensions, as measured over the surface. More typical dimensions may be at least 60cm, preferably at least 1m in at least one and preferably two dimensions, as measured across the surface of the sheet. The sheet thickness will be sufficient to support the weight of the construction material but will generally be less than 5 cm, preferably less than 3 cm. Suitable construction materials include, but are not limited to, tiles or windowpanes or other glass sheets, including translucent and opaque panels.

In the uses and methods described above, the heterojunction is preferably a solid-state heterojunction according to the invention.

Solid-state heterojunctions and optoelectronic devices formed or formable by any of the methods herein described self-evidently also form part of the invention.

The n-type layer, p-type layer, perovskite layers, p-type organic hole transporter materials, layers of the optical multilayer, and permeable barrier layers described herein may be formed by any suitable method. Examples of such methods and approaches will be well-known to those skilled in the art. For deposition of planar perovskite layers, for instance, suitable methods of deposition include those described in M. Liu, M. Johnston and H. J. Snaith, Nature 2013, volume 501, page 395. and G. E. Eperon et al. Adv. Funct. Mater. 2014, 24, 151-157, such as vapour deposition (e.g. dual-source vapour deposition) and solution processing (including spin-coating, spray coating, ultra-sonic spray deposition, doctor blade coating, slot dye coating, gravure printing, and inkjet printing). Spin coating (or other solution processing techniques such as spray coating, doctor blade coating, slot dye coating, gravure printing, and inkjet printing) may also be employed for deposition of mesoporous scaffold materials and for deposition of perovskites thereon. Alternatively the mesoporous scaffold may be deposited by spin-coating. Compact layers of metal oxides such as $TiO_2$ may typically be deposited by spin-coating; appropriate apparatus and solvents will be readily determined by those skilled in the art. The step of forming an insulating barrier layer may be performed by any method suitable for generating a porous insulating layer from the material to be employed. Such methods include formation of a polymeric porous sheet and placing that between the perovskite and the cathode, depositing the material by evaporation, spraying (e.g. spray pyrolysis) or sputter deposition, or by forming a paste of insulating particles, followed by heating/sintering. Deposition of the electron absorbing organic layer may for example be achieved simply by immersing a substrate in a solution of the material intended for the SAM for a suitable period of time. Non-limiting examples of suitable methods are described in the Examples below.

Preferred embodiments of the invention are outlined in the following non-limiting numbered clauses:

1. A solid-state heterojunction comprising a photoactive layer comprising a photoactive perovskite and an optical

multilayer in contact with the photoactive layer.

2. A solid-state heterojunction according to clause 1 which is a solid-state heterojunction comprising:

a photoactive layer comprising a photoactive perovskite,
an n-type layer,
an optical multilayer interposed between the photoactive layer and the n-type layer, and optionally
a p-type layer separated from the optical multilayer by the photoactive layer.

3. A solid-state heterojunction according to clause 1 which is a solid-state inverted heterojunction comprising:

a photoactive layer comprising a photoactive perovskite,
a p-type layer,
an optical multilayer interposed between the photoactive layer and the p-type layer, and optionally
an n-type layer separated from the optical multilayer by the photoactive layer.

4. A solid-state heterojunction according to any of clauses 1 to 3 wherein the optical multilayer comprises at least one high porosity layer having a porosity of about 40% or above and at least one low porosity layer having a porosity of about 10% or below.

5. A solid-state heterojunction according to clause 4 wherein the at least one high porosity layer and the at least one low porosity layer each independently comprise a material chosen from among $SiO_2$, $TiO_2$, $SnO_2$, ZnO, $ZrO_2$, $Nb_2O_5$ $CeO_2$, $Fe_2O_3$, $Fe_3O_4$, $V_2O_5$, $Cr_2O_3$, $HfO_2$, $MnO_2$, $Mn_2O_3$, $Co_3O_4$, NiO, $Al_2O_3$, $In_2O_3$, $SnO_2$, CdS, CdSe, ZnS, ZnSe, Ni, Co, Fe, Ag, Au, Se, Si and Ge, preferably wherein the at least one high porosity layer comprises $SiO_2$ and the at least one low porosity layer comprises $TiO_2$.

6. A solid-state heterojunction according to any of clauses 1 to 5 wherein the optical multilayer is at least partially infiltrated by the photoactive perovskite.

7. A solid-state heterojunction according to any of clauses 1 to 6 wherein the optical multilayer has an overall thickness of below about 800 nm.

8. A solid-state heterojunction according to any of clauses 1 to 7 wherein the optical multilayer is configured to provide a perceived hue falling within the colour gamut defined by the following vertices in the CIE 1931 xy chromaticity diagram: (0.27, 0.51), (0.17, 0.42), (0.17, 0.14), (0.22, 0.12), (0.48, 0.34) and (0.46, 0.44).

9. A solid-state heterojunction according to any of clauses 1 to 8 wherein the optical multilayer is a one-dimensional photonic crystal (1DPC).

10. A solid-state heterojunction according to any of clauses 1 to 9 wherein the light-absorbing perovskite is selected from among:

ammonium trihalogen plumbates (e.g. $CH_3NH_3PbI_3$, $CH_3NH_3PbCl_3$, $CH_3NH_3PbF_3$ and $CH_3NH_3PbBr_3$);
mixed-halide ammonium trihalogen plumbates with general formula $CH_3NH_3Pb[Hal1]_{3-x}[Hal2]_x$, wherein [Hall] and [Hal2] are independently selected from among F, Cl, Br and I, with the proviso that [Hall] and [Hal2] are non-identical, and wherein $0 \leq x \leq 3$;
$CsSnX_3$ perovskites wherein X is selected from among F, Cl, Br and I, preferably I;
organometal trihalide perovskites with the general formula $(RNH_3)BX_3$ where R is $CH_3$, $C_nH_{2n}$ or $C_nH_{2n+1}$, $2 \leq n \leq 10$, X is selected from among F, Cl, Br and I, and B is Pb or Sn;
and combinations thereof.

11. A solid-state heterojunction as described in any preceding clause, further comprising a cathode, preferably a metal, metallic, or transparent conducting oxide cathode.

12. A solid-state heterojunction as described in any preceding clause, further comprising an anode, preferably a metal, metallic, or transparent conducting oxide anode

12. A solid -state heterojunction as described in any preceding clause, further comprising a permeable barrier layer comprising at least one porous insulating material.

13. A solid-state heterojunction as described in any preceding clause, further comprising a glass substrate, e.g. an FTO-coated glass substrate.

14. A solid-state heterojunction as described in any preceding clause, having at least one of the following:

(i) an open-circuit voltage ($V_{OC}$) of at least 0.9 V
(ii) a short-circuit current ($J_{SC}$) of at least 7 $mAcm^{-2}$
(iii) a fill factor (FF) of at least 0.6
(iv) a power conversion efficiency ($\eta$) of at least 4%;
(v) a colour hue comprised within the colour gamut defined by the following vertices in the CIE 1931 xy chromaticity diagram: (0.27, 0.51), (0.17, 0.42), (0.17, 0.14), (0.22, 0.12), (0.48, 0.34) and (0.46, 0.44),

when measured under simulated AM 1.5 $100mWcm^{-2}$ sunlight.

15. A solid-state heterojunction comprising:

(i) a cathode (preferably a metal, metallic, or transparent conducting oxide cathode);
(ii) optionally a permeable barrier layer of insulating material;
(iii) a p-type layer, preferably comprising an organic p-type material;
(iv) a photoactive perovskite layer;
(v) an optical multilayer;
(vi) an n-type layer;
(vii) an FTO-coated glass substrate.

16. A solid-state inverted heterojunction comprising:

(i) an anode (preferably a metal, metallic, or transparent conducting oxide anode);
(ii) an n-type layer;
(iii) a photoactive perovskite layer;
(iv) an optical multilayer;
(v) optionally a p-type layer, preferably comprising an organic p-type material;
(vi) an FTO-coated glass substrate.

17. An optoelectronic device comprising at least one solid-state heterojunction as defined in clauses 1 to 16.

18. A construction material comprising at least one optoelectronic device as defined in clause 17.

19. Use of an optical multilayer in a solid-state heterojunction comprising a photoactive perovskite.

20. A method of providing structural colour in a solid-state heterojunction comprising a photoactive perovskite, said method comprising

(i) providing an optical multilayer; and
(ii) incorporating said optical multilayer into a solid-state heterojunction comprising a photoactive perovskite.

21. A method for the manufacture of a solid-state heterojunction comprising a photoactive layer comprising a photoactive perovskite, an n-type layer, and an optical multilayer interposed between the photoactive layer and the n-type layer, said method comprising:

a) coating an anode, preferably a transparent anode (e.g. a Fluorine doped Tin Oxide (FTO) anode) with a layer of an n-type material, preferably a metal oxide;
b) forming an optical multilayer on at least a portion of a surface of said n-type layer;
c) forming a layer of a photoactive perovskite contacting said optical multilayer;
e) optionally forming a layer of a p-type material in contact with said layer of photoactive perovskite;
f) optionally forming a permeable barrier layer comprising at least one porous (meso or micro) insulating material;

g) optionally forming a cathode, preferably a metal or metallic cathode (e.g. a silver or gold cathode), a transparent conducting oxide cathode, or a cathode formed from metal nanowires.

22. A method for the manufacture of a solid-state inverted heterojunction comprising a photoactive layer comprising a photoactive perovskite, a p-type layer, an optical multilayer interposed between the photoactive layer and the p-type layer, and an n-type layer separated from the optical multilayer by the photoactive layer, said method comprising:

a) coating a cathode, preferably a transparent cathode (e.g. a Fluorine doped Tin Oxide (FTO) cathode) with a layer of a p-type material;
b) forming an optical multilayer on at least a portion of a surface of said layer of a p-type material;
c) forming a layer of a photoactive perovskite contacting said optical multilayer;
e) optionally forming a layer of an n-type material in contact with said layer of photoactive perovskite;
f) optionally forming a permeable barrier layer comprising at least one porous (meso or micro) insulating material;
g) optionally forming an anode, preferably a metal or metallic anode (e.g. a silver or gold anode), a transparent conducting oxide anode, or an anode formed from metal nanowires.

23. An optical multilayer comprising alternate layers of a first material having a first porosity and a second material having a second porosity, wherein the second porosity is higher than the first porosity.

24. The heterojunction of clauses 1 to 16 comprising an optical multilayer as described in clause 23.

25. A solid-state heterojunction formed or formable by the method of any of clauses 20 to 22.

26. An optoelectronic device comprising at least one solid-state heterojunction formed or formable by the method of any of clauses 20 to 22.

The invention is illustrated further in the following non-limiting Examples.

**Example 1: Preparation of one dimensional photonic crystals (1DPCs)**

1DPCs using a $TiO_2$ dispersion, a suspension of $SiO_2$ nanoparticles and a solution of polystyrene were obtained by liquid processing. $TiO_2$ dispersion was obtained by mixing titanium tetraisopropoxide in an ethanolic solution of hydrochloric acid. $SiO_2$ colloids (Ludox TMA, Aldrich) and Polystyrene ($M_w$ 280,000 Aldrich) were diluted in methanol to 3 wt % and toluene to 0.5 wt %, respectively. Fluorine-doped tin oxide (FTO) coated glass (TEC 7, 7Ω/□) was used as a substrate in this work.

Initially, FTO was removed from regions under the anode contact by etching the FTO with 2M HCl and zinc powder. Substrate was then cleaned sequentially in 2% hellmanex detergent, acetone, propan-2-ol and oxygen plasma. Photonic crystals were built by an alternated deposition of the three compounds over FTO glass using a spin coater (Laurell WS-400E-6NPP) in which both the acceleration ramp and the final rotation speed could be precisely determined. The first layer was deposited using 200 μL of $TiO_2$ dispersion and then the sample was accelerated up to different final speeds with nominal value between 2000 and 3000 rpm. The total spin-coating process (ramping-up and final speed) was completed in 60 s. Then, the sample was treated at a temperature of 500°C during 200 seconds in order to densify the $TiO_2$ film. After cooling in a metal surface, 200 μL of $SiO_2$ nanoparticles solution was deposited using final speeds with nominal value between 3000 and 8000 rpm for 60 s. In order to fill the voids network of this last layer, 200 μL of polystyrene dilution was spin-coated at 4500 rpm for 60 s, allowing the next $TiO_2$ film deposition without penetration within the $SiO_2$ nanoparticles layer. The sample was heated again at 500°C during 200 seconds, removing the polystyrene and densifying the $TiO_2$ film. These sequential depositions gave rise to 3 layers of the final photonic crystal. The process was repeated until a total of 7 layers were deposited and finally the sample was treated at 500°C during 30 min to completely stabilize it.

**Example 2: Perovskite solution preparation.** Methylammonium iodide ($CH_3NH_3I$) was prepared by reacting methylamine, 33 wt% in ethanol (Sigma-Aldrich), with hydroiodic acid (HI) 57 wt% in water (Sigma-Aldrich), at room temperature. HI was added dropwise while stirring. In principle, after reaction and purification the ratio of methylamine to HI should be about 1:1, but more methylamine was employed initially in order to prevent oxidation of HI. Typical quantities employed were 24 mL methylamine, 10 mL hydroiodic acid and 100 mL ethanol. Upon drying at 100 °C, a white powder was formed, which was dried overnight in a vacuum oven and purified with ethanol before use. To generate the perovskite solution, $CH_3NH_3I$ and $PbCl_2$ (Sigma-Aldrich) were dissolved in anhydrous N,N-Dimethylformamide (DMF) at a 3:1 molar ratio with final concentrations of ~40 wt%.

**Example 3: Perovskite deposition.** For devices, the perovskites were prepared by spin-coating a 40 wt%

perovskite solution at 2000 rpm in a nitrogen-filled glovebox. After spin-coating, the films were annealed at 100 °C for 2h. The spiro-OMeTAD hole-transporting layer was then deposited from a 80 mM chlorobenzene solution containing additives of lithium bis(trifluoromethanesulfonyl)imide and 4-tert-butylpyridine. Finally, 50 nm gold electrodes were thermally evaporated under vacuum of ~$10^{-6}$ Torr, at a rate of ~0.1nm/s, to complete the devices.

**Example 4: Characterization.**

Cross-section field emission scanning electron microscopy (FESEM) images of multilayers and corresponding full devices were taken by using a microscope Hitachi 5200 operating at 5kV. The spectral optical response of the multilayers and full devices were obtained using a light source (Ocean Optics HL-2000) as the incident beam and an integrating sphere (Labsphere RTC-060-SF). The current density-voltage (J-V) curves were measured (2400 Series SourceMeter, Keithley Instruments) under simulated AM 1.5 sunlight at 100 $mWcm^{-2}$ irradiance generated by an Abet Class AAB sun 2000 simulator, with the intensity calibrated with an NREL calibrated KG5 filtered Si reference cell. The mismatch factor was calculated to be less than 1%. The solar cells were masked with a metal aperture to define the active area, typically 0.0625 $cm^2$ (measured individually for each mask) and measured in a light-tight sample holder to minimize any edge effects and ensure that the reference cell and test cell are located in the same spot under the solar simulator during measurement. External quantum efficiency (EQE) was measured via fourier-transform photocurrent spectroscopy using the modulated beam of a Bruker Vertex 80v Fourier Transform Interferometer with tungsten lamp source and a Stanford Research SR570 current preamplifier. Samples were calibrated to a Newport-calibrated reference silicon solar cell with a known external quantum efficiency. The solar cells were masked with a metal aperture to define the active area, typically 0.0625 $cm^{-2}$.

**Example 5:** In Figure 6 we show the subsequent photovoltaic performance of the colourful perovskite solar cells. We commence with the spectral response, where in Figure 6a, b and c, we show the different response of solar cells constructed with no photonic crystal, and with an orange and blue-green reflective optical band gap. Clearly, as the photonic band gap moves from high to lower energy across the spectrum, the redder section of the photoactive region of the perovskite absorber is reflected. In Figure 6 we also show the performance parameters for a series of solar cells with a range of photonic band gaps, measured under simulated AM1.5 sun light at 100 $mWcm^{-2}$ irradiance, with the parameters summarized in Table 1.

Table 1 | Solar cell performance parameters.

| colour of device | | Jsc (mA/cm2) | PCE (%) | Voc (V) | FF |
|---|---|---|---|---|---|
| blue | best | 13.4 | 8.8 | 0.98 | 0.67 |
| | average | 12.1 ± 1.2 | 7.6 ± 0.9 | 0.94 ± 0.02 | 0.67 ± 0.02 |
| Blue-green | best | 10.4 | 7.0 | 0.95 | 0.71 |
| | average | 10.1 ± 0.3 | 6.5 ± 0.4 | 0.93 ± 0.02 | 0.68 ± 0.03 |
| green | best | 9.9 | 6.7 | 0.92 | 0.74 |
| | average | 9.4 ± 0.4 | 6.0 ± 0.4 | 0.92 ± 0.02 | 0.69 ± 0.03 |
| orange | best | 9.9 | 6.6 | 0.95 | 0.71 |
| | average | 8.9 ± 0.9 | 5.4 ± 0.8 | 0.91 ± 0.03 | 0.66 ± 0.05 |
| red | best | 7.6 | 4.5 | 0.93 | 0.62 |
| | average | 7.2 ± 0.5 | 4.1 ± 0.4 | 0.91 ± 0.02 | 0.61 ± 0.01 |

The first encouraging observation is that the solar cells operate well, despite the requirement for conduction through the photonic multilayer, consistent with the perovskite absorber bridging the conduction through it. The short circuit current density ($J_{sc}$) monotonically decreases with the increase of the multilayer lattice parameter from blue to red. However, the open-circuit voltage (Voc) and fill factor (FF) are only slightly varying, displaying independence of the multilayer lattice parameter. We also observe that for blue, blue-green and green hues, the power conversion efficiency (PCE) of the best performing devices are all above 6%, with the peak of 8.8% being achieved for the blue cells, showing good potential of making efficient working devices with vivid and tuneable colours.

As a comparison, we show the performance of perovskite solar cells with -370 nm thick mesoporous $SiO_2$ as a porous scaffold in Figure 4, which exhibit a peak and average PCE of 10.5 and 9.5% respectively, indicating reasonable retention of the expected performance for the multilayer scaffold containing perovskite solar cells.

The stabilised power output of perovskite solar cell, that measured under constant load under illumination, is often lower than the efficiency determined from the current voltage curves.[ Snaith, H. J.; Abate, A.; Ball, J. M.; Eperon, G. E.; Leijtens, T.; Noel, N. K.; Stranks, S. D.; Wang, J. T.-W.; Wojciechowski, K.; Zhang, W. J. Phys. Chem. Lett. 2014, 5 (9), 1511-1515.] We show results for the stabilised power output of the cells studied here in Figure 5. As an example, a blue cell which showed a maximum JV determined efficiency of 7.9%, exhibited a stabilised power output of 6.6%.

**Example 6**

We show a schematic of the structure of the perovskite solar cell incorporating the multilayer with 1DPC properties in Figure 1a and a scanning electron microscopy (SEM) image of a cross section of such a device in Figure 1b. The photonic band gap of the multilayer is easily controlled by changing the thickness of individual layers of either low porosity$TiO_2$ or highly porous $SiO_2$, consequently, the reflectance peak position can be controlled precisely. As we show in the photographs of constructed solar cells in Figure 1c, the obtained devices show intense colours variable across the visible spectrum. These vivid iridescent colours are achieved by the combination of reflection from the PC and strong absorption from the overlying perovskite thin film. We note that our structure is very similar to the beetles' wing.

**Example 7: Comparative example**

Perovskite solar cells were constructed by forming a polycrystalline layer of an organic-inorganic metal halide perovskite, typically $CH_3NH_3PbI_3$ or the mixed halide variant $CH_3NH_3PbI_{3-x}Cl_x$, sandwiched between an n-type and p-type charge collection layer.

In order to introduce photonic colour, we introduced a nanoparticle based one dimensional photonic crystal (1DPC) comprising alternating mesoporous $TiO_2$ and $SiO_2$ layers, following a similar approach to that previously employed in the field of dye-sensitized solar cells (DSCs).

Although we did obtain vivid visible colour through this route, it was only possible with thick 1DPC films (above 800 nm), thicker than the thickness optimum solar cell operation of 300 to 500 nm, and the consequent devices performed poorly, as we show in Figure 3.

**Example 8: Modelling**

To obtain an in-depth understanding of the optical effects of perovskite solar cells incorporating optical multilayers, a theoretical model was developed using a method based on the transfer matrix formalism ("Optical Description of Mesostructured Organic-Inorganic Halide Perovskite Solar Cells", Miguel Anaya, Gabriel Lozano, Mauricio Ernesto Calvo, Wei Zhang, Michael B Johnston, Henry J. Snaith, and Hernan Miguez, J. Phys. Chem. Lett., 2015, 6 (1), 48-53), which allowed calculation of the electric field intensity within the layered structure and thus visualisation of the effect of integrating the multilayer on the spatial distribution of the radiation in the photovoltaic device.

A perovskite solar cell which integrates one dimensional photonic crystals in which low and high porosity layers are alternated, is herein modelled through a layered structure. The incoming and outgoing media are considered to be the glass substrate and the air. In our model, the optical effects due to the presence of all layers comprising the photovoltaic device are accounted for, i.e. glass, FTO, photonic crystal infiltrated by perovskite, perovskite capping layer, spiro-OMeTAD, gold and air. This theoretical model serves to describe the optical reflectance of the multilayer-based devices shown as solid lines in Figure 2 (a). As in the experiments, the calculation considers a plane wave that impinges perpendicularly to the electrode and therefore to the stacking of dielectric layers. To attain the R of the cell, the reflection coefficient of the field in the incident medium is calculated using a method based on the transfer matrix formalism. Moreover, the model herein proposed permits calculating the electric field intensity within the layered structure, which facilitates to visualize the effect of integrating the optical multilayer on the spatial distribution of the radiation in the photovoltaic device.

To check the suitability of the proposed theoretical model, we calculate the reflectance of photonic multilayer based cells varying the thickness of each layer comprising the unit cell is a fitting parameter. Good agreement between calculated and experimental reflectance spectra measured at normal incidence is attained, as displayed in Figure 2 (a). From the calculation, the lattice parameters of the periodic stack are estimated to be 129 nm ($d_H$ = 39 nm, $d_L$ = 90 nm) for the *blue-green,* and 145 nm ($d_H$ = 58 nm, $d_L$ = 87 nm) for the *orange* 1DPC-based cell. The colours exhibited by these devices originate from the way the optical field is distributed in the multilayer, as explicitly shown in Figure 2 (b-c). We show a colour scale to indicate the field intensity at each wavelength (horizontal axis) and position (vertical axis) within the cell. From the calculation of the fields, it is apparent that the observed reflectance peaks are primarily due to the high field intensity in the incoming medium at certain frequencies as a result of interference between light reflected and transmitted at each interface.

In order to characterize the colour hue of the multilayer-based photovoltaic devices labelled as *blue-green* and

*orange,* we calculate their colour coordinates and display the results as black symbols on the CIE 1931 chromacity diagram in Figure 2 (d). Finally, we can make use of our theoretical model to calculate the reflectance of photovoltaic devices that integrate 1DPCs comprising different unit cells. From the model we can extrapolate the full range of colours that can be eventually achieved by means of a careful design of the structural properties of the photonic crystals infiltrated by perovskite. Such colours are encompassed by the dashed polygon in Figure 2 (d).

**Example 9: Analysis via FESEM (field emission scanning electron microscopy)**

Devices manufactured in accordance with the invention were imaged using FESEM.

The complete infiltration of perovskite in such multilayers was confirmed by the backscattered electrons FESEM image (Figure 7b). Backscattered electrons are directly related to the atomic number of the elements present the analysed samples. In our case, we have used this technique to find out how the perovskite is distributed along the different layers. Heavier elements appear (in our images) as shinier zones. The brightest regions on top and bottom of the Figure 7b correspond to the perovskite capping layer and the FTO substrate, respectively. If there was no perovskite infiltration in the photonic crystal scaffold, the interlayers between FTO and perovskite capping layer would be more shadowy, being darker the SiO2 layers (lighter compound) than the TiO2 layers (heavier compound). In our multilayer it is observed the opposite behaviour. SiO2 layers have bright dots and it is due to perovskite infiltration (Pb is much heavier than Ti). On the other hand, the quantity of infiltrated perovskite within the TiO2 is much lower, giving rise to the darkest regions of the image. In fact, it can be appreciated how the perovskite is accumulated on top of each TiO2 layer. In particular, the first dense TiO2 layer also acts as a hole blocking layer, avoiding the direct contact between Spiro-OMeTAD and FTO glass. Figure 7a is very helpful to know where the different layers of the photonic crystal are placed: thinner ones are TiO2 and thicker ones are SiO2.

## Claims

1. A solid-state heterojunction comprising a photoactive layer comprising a photoactive perovskite and an optical multilayer in contact with the photoactive layer.

2. A solid-state heterojunction according to claim 1 which is a solid-state heterojunction comprising:

    a photoactive layer comprising a photoactive perovskite,
    an n-type layer,
    an optical multilayer interposed between the photoactive layer and the n-type layer, and optionally
    a p-type layer separated from the optical multilayer by the photoactive layer.

3. A solid-state heterojunction according to claim 1 which is a solid-state inverted heterojunction comprising:

    a photoactive layer comprising a photoactive perovskite,
    a p-type layer,
    an optical multilayer interposed between the photoactive layer and the p-type layer, and optionally
    an n-type layer separated from the optical multilayer by the photoactive layer.

4. A solid-state heterojunction according to any of claims 1 to 3 wherein the optical multilayer comprises at least a first and a second layer wherein the first and the second layer differ in refractive index by at least 1.

5. A solid-state heterojunction according to any of claims 1 to 4 wherein the optical multilayer comprises at least one high porosity layer having a porosity of about 40% or above and optionally at least one low porosity layer having a porosity of about 10% or below, preferably wherein the at least one high porosity layer and the at least one low porosity layer each independently comprise a material chosen from among $SiO_2$, $TiO_2$, $SnO_2$, ZnO, $ZrO_2$, $Nb_2O_5$, $CeO_2$, $Fe_2O_3$, $Fe_3O_4$, $V_2O_5$, $Cr_2O_3$, $HfO_2$, $MnO_2$, $Mn_2O_3$, $Co_3O_4$, NiO, $Al_2O_3$, $In_2O_3$, $SnO_2$, CdS, CdSe, ZnS, ZnSe, Ni, Co, Fe, Ag, Au, Se, Si and Ge, preferably wherein the at least one high porosity layer comprises $SiO_2$ and the at least one low porosity layer comprises $TiO_2$.

6. A solid-state heterojunction according to any of claims 1 to 5 wherein the optical multilayer is at least partially infiltrated by the photoactive perovskite.

7. A solid-state heterojunction according to any of claims 1 to 6 wherein the optical multilayer is a one-dimensional

photonic crystal (1DPC).

**8.** A solid-state heterojunction as claimed in any preceding claim, having at least one of the following:

(i) an open-circuit voltage ($V_{OC}$) of at least 0.9 V
(ii) a short-circuit current ($J_{SC}$) of at least 7 $mAcm^{-2}$
(iii) a fill factor (FF) of at least 0.6
(iv) a power conversion efficiency ($\eta$) of at least 4%;
(v) a colour hue comprised within the colour gamut defined by the following vertices in the CIE 1931 xy chromaticity diagram: (0.27, 0.51), (0.17, 0.42), (0.17, 0.14), (0.22, 0.12), (0.48, 0.34) and (0.46, 0.44),

when measured under simulated AM 1.5 100$mWcm^{-2}$ sunlight.

**9.** An optoelectronic device comprising at least one solid-state heterojunction as defined in claims 1 to 8.

**10.** A construction material comprising at least one optoelectronic device as defined in claim 9.

**11.** Use of an optical multilayer in a solid-state heterojunction comprising a photoactive perovskite.

**12.** A method of providing structural colour in a solid-state heterojunction comprising a photoactive perovskite, said method comprising

(i) providing an optical multilayer; and
(ii) incorporating said optical multilayer into a solid-state heterojunction comprising a photoactive perovskite.

**13.** A method for the manufacture of a solid-state heterojunction comprising a photoactive layer comprising a photoactive perovskite, an n-type layer, and an optical multilayer interposed between the photoactive layer and the n-type layer, said method comprising:

a) coating an anode, preferably a transparent anode (e.g. a Fluorine doped Tin Oxide (FTO) anode) with a layer of an n-type material, preferably a metal oxide;
b) forming an optical multilayer on at least a portion of a surface of said n-type layer;
c) forming a layer of a photoactive perovskite contacting said optical multilayer;
e) optionally forming a layer of a p-type material in contact with said layer of photoactive perovskite;
f) optionally forming a permeable barrier layer comprising at least one porous (meso or micro) insulating material;
g) optionally forming a cathode, preferably a metal or metallic cathode (e.g. a silver or gold cathode), a transparent conducting oxide cathode, or a cathode formed from metal nanowires.

**14.** An optical multilayer comprising alternate layers of a first material having a first porosity and a second material having a second porosity, wherein the second porosity is higher than the first porosity.

**15.** The heterojunction of claims 1 to 8 comprising an optical multilayer as claimed in claim 14.

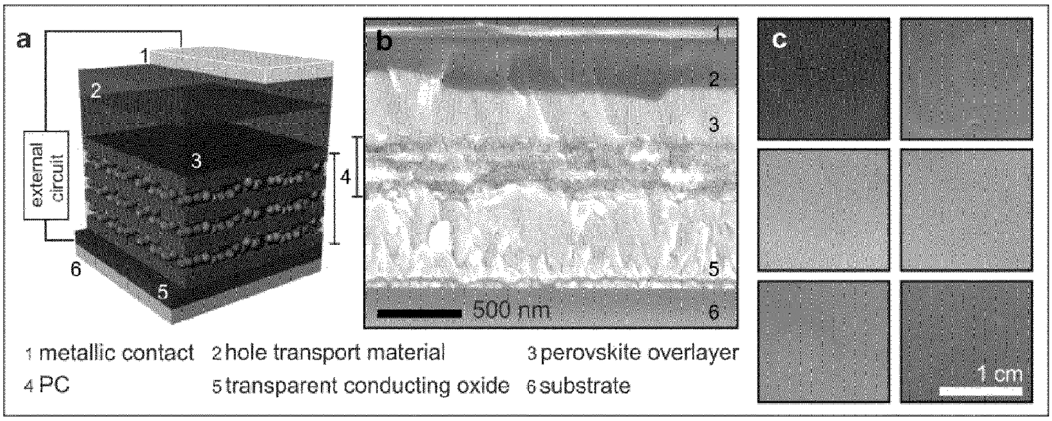


Figure 1

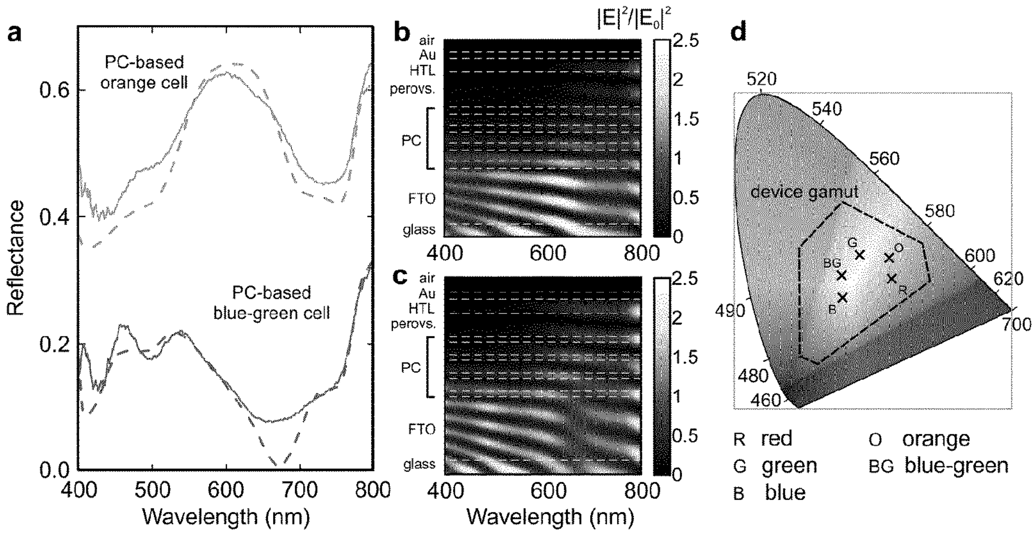


Figure 2

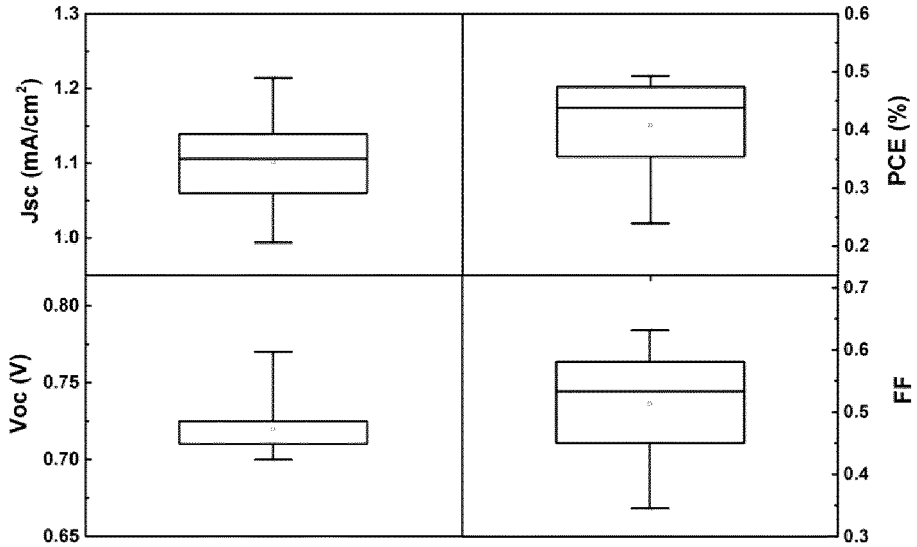


Figure 3

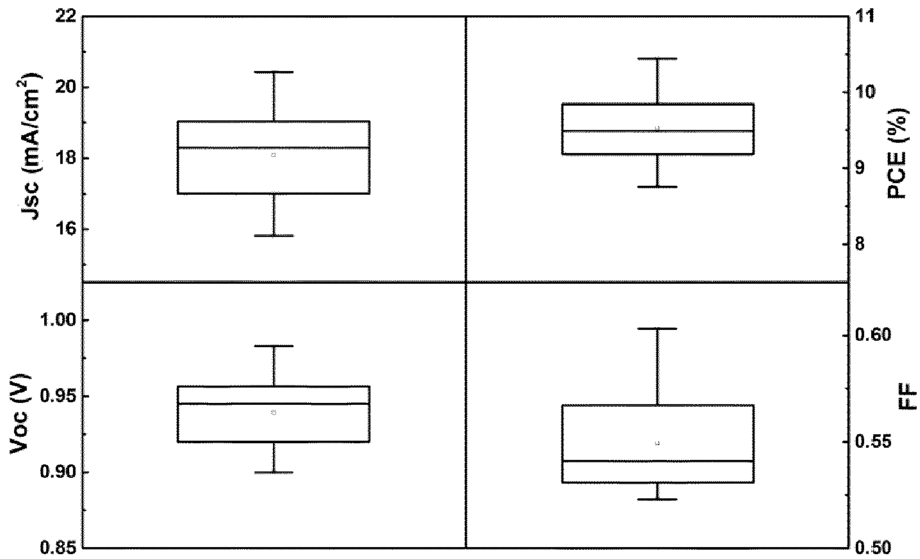


Figure 4

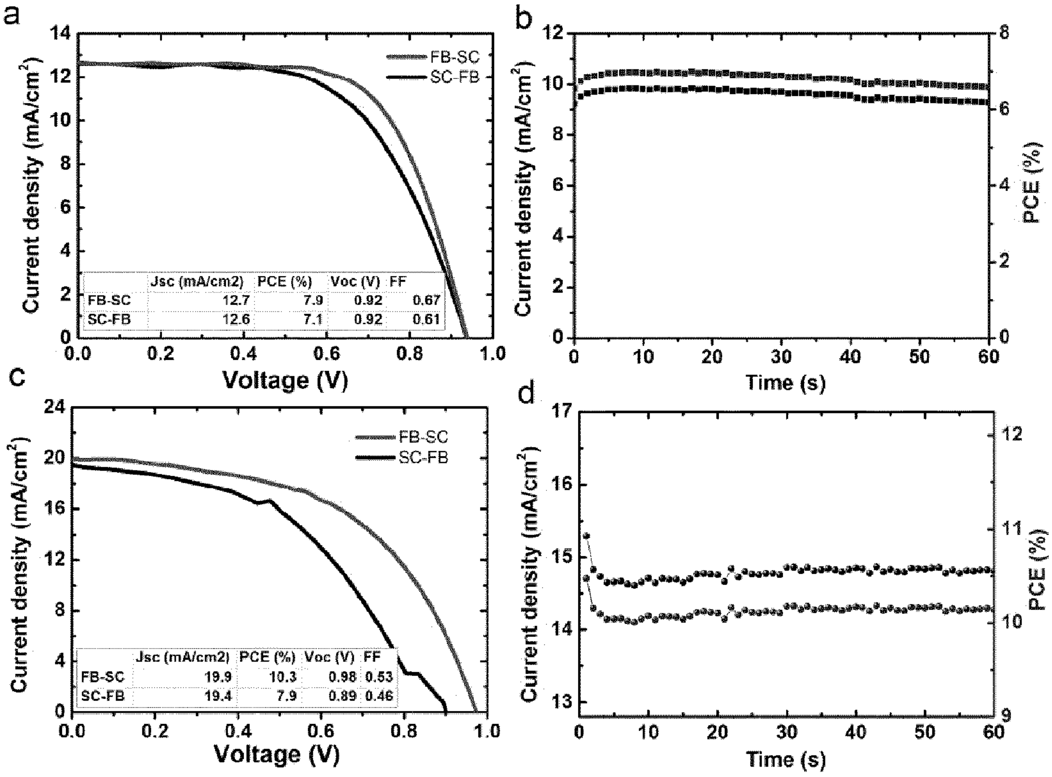


Figure 5

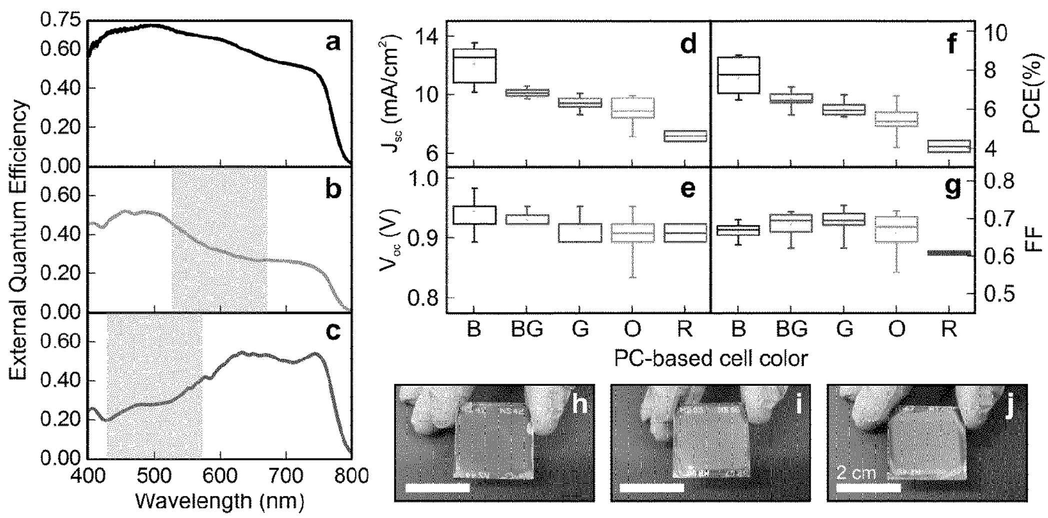


Figure 6

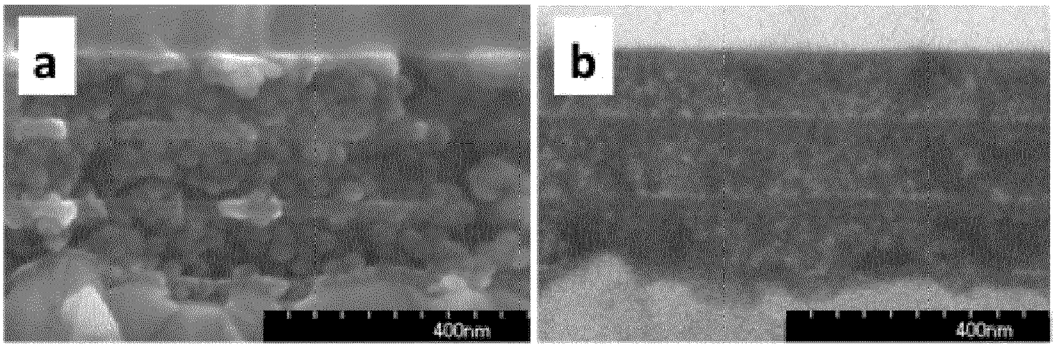


Figure 7

Europäisches Patentamt
European Patent Office
Office européen des brevets

# EUROPEAN SEARCH REPORT

Application Number
EP 15 38 2026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JAMES M. BALL ET AL: "Low-temperature processed meso-superstructured to thin-film perovskite solar cells", ENERGY & ENVIRONMENTAL SCIENCE, vol. 6, no. 6, 1 April 2013 (2013-04-01), page 1739, XP55114910, ISSN: 1754-5692, DOI: 10.1039/c3ee40810h | 1,2,6, 8-13 | INV. H01L51/42 ADD. H01L51/44 |
| A | * abstract; figure 1 * | 3-5,7, 14,15 | |
| X,D | COLODRERO ET AL.: ADVANCED MATERIALS, vol. 21, 16 December 2008 (2008-12-16), pages 764-770, XP7914262, | 14,15 | |
| A | * the whole document * | 1-13 | |
| X | WO 2014/045021 A1 (ISIS INNOVATION [GB]) 27 March 2014 (2014-03-27) | 1,2,6, 8-12 | |
| A | * abstract; figures 1-20 * | 3-5,7, 13-15 | |
| A,D | WO 2009/127692 A2 (NANOLOGICA AB [SE]; MIGUEZ HERNAN [ES]; COLODRERO SILVIA [ES]) 22 October 2009 (2009-10-22) * the whole document * | 1-15 | TECHNICAL FIELDS SEARCHED (IPC) H01L H01G |
| A | WO 2007/040601 A1 (UNIV CALIFORNIA [US]; LEE KWANGHEE [US]; HEEGER ALAN J [US]) 12 April 2007 (2007-04-12) * the whole document * | 1-15 | |

The present search report has been drawn up for all claims

1

| Place of search | Date of completion of the search | Examiner |
|---|---|---|
| The Hague | 9 July 2015 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 15 38 2026

This annex lists the patent family members relating to the patent documents cited in the above-mentioned European search report. The members are as contained in the European Patent Office EDP file on
The European Patent Office is in no way liable for these particulars which are merely given for the purpose of information.

09-07-2015

| Patent document cited in search report | Publication date | Patent family member(s) | Publication date |
|---|---|---|---|
| WO 2014045021 A1 | 27-03-2014 | AU 2013319979 A1 | 19-03-2015 |
| | | EP 2898553 A1 | 29-07-2015 |
| | | KR 20150056851 A | 27-05-2015 |
| | | WO 2014045021 A1 | 27-03-2014 |
| WO 2009127692 A2 | 22-10-2009 | AU 2009237663 A1 | 22-10-2009 |
| | | CN 102027556 A | 20-04-2011 |
| | | EP 2263244 A2 | 22-12-2010 |
| | | JP 5548185 B2 | 16-07-2014 |
| | | JP 2011517839 A | 16-06-2011 |
| | | NZ 588241 A | 26-04-2013 |
| | | RU 2010146990 A | 27-07-2012 |
| | | US 2011030792 A1 | 10-02-2011 |
| | | WO 2009127692 A2 | 22-10-2009 |
| WO 2007040601 A1 | 12-04-2007 | EP 1859495 A1 | 28-11-2007 |
| | | JP 2008533745 A | 21-08-2008 |
| | | WO 2007040601 A1 | 12-04-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20110030792 A, Miguez


### Non-patent literature cited in the description


- **COLODRERO et al.** *Advanced Materials,* 2009, vol. 21, 764-770
- **COLONNA et al.** *Energy & Environmental Science,* 2012, vol. 5, 8238-8243
- **M. ANAYA et al.** *JACS,* 2013, vol. 135, 7803
- **M.E. CALVO et al.** *Adv. Funct. Mater.,* 2008, vol. 18, 2708-2715
- **J. ROUQUEROL et al.** Recommendations for the Characterization of Porous Solids. *Pure & Appl. Chem.,* 1994, vol. 66 (8), 1739-1758
- **SING et al.** *Pure & Appl. Chem.,* 1985, vol. 57 (4), 603-919
- Manual on Catalyst Characterization. **J. HABER.** Pure & Appl. Chem. 1991, vol. 63, 1227-1246
- **EPERON et al.** *ACS Nano,* 2014, vol. 8 (1), 591-598
- **SNAITH et al.** *Applied Physics Letters,* 2006, vol. 89, 262114
- **HORIUCHI et al.** *J Am. Chem. Soc.,* 2004, vol. 126, 12218-12219
- **KUANG et al.** *Nano Letters,* 2006, vol. 6, 769-773
- **SNAITH et al.** *Angew. Chem. Int. Ed.,* 2005, vol. 44, 6413-6417
- **WANG et al.** *Nature Materials,* 2003, vol. 2, 402-498
- **KUANG et al.** *Inorganica Chimica Acta,* 2008, vol. 361, 699-706
- **SNAITH et al.** *J Phys, Chem. Lett.,* 2008, vol. 112, 7562-7566
- **REDDY et al.** *Angew. Chem. Int. Ed.,* 2007, vol. 46, 373-376
- **BURKE et al.** *Chem. Commun.,* 2007, 234
- **MCNEILL et al.** *Appl. Phys. Lett.,* 2007, 90
- **S. M. SZE.** Semiconductor Devices Physics and Technology. Wiley, 54
- **M. LIU ; M. JOHNSTON ; H. J. SNAITH.** *Nature,* 2013, vol. 501, 395
- **G. E. EPERON et al.** *Adv. Funct. Mater.,* 2014, vol. 24, 151-157
- **SNAITH, H. J. ; ABATE, A. ; BALL, J. M. ; EPERON, G. E. ; LEIJTENS, T. ; NOEL, N. K. ; STRANKS, S. D. ; WANG, J. T.-W. ; WOJCIECHOWSKI, K. ; ZHANG, W.** *J. Phys. Chem. Lett.,* 2014, vol. 5 (9), 1511-1515
- **MIGUEL ANAYA ; GABRIEL LOZANO ; MAURICIO ERNESTO CALVO ; WEI ZHANG ; MICHAEL B JOHNSTON ; HENRY J. SNAITH ; HERNAN MIGUEZ.** Optical Description of Mesostructured Organic-Inorganic Halide Perovskite Solar Cells. *J. Phys. Chem. Lett.,* 2015, vol. 6 (1), 48-53